# EUROPEAN PATENT APPLICATION

(11) **EP 4 593 414 A1**
(43) Date of publication of application: **30.07.2025**
(21) Application number: 23883132.5
(22) Date of filing: 26.10.2023
(51) Int. Cl.: H04R 1/10, F16C 11/04, H01F 7/00

(54) **FOLDABLE ELECTRONIC DEVICE**

(30) Priority: 26.10.2022 KR 20220139689
(71) Applicant: Samsung Electronics Co., Ltd., Suwon-si, Gyeonggi-do 16677 (KR)
(72) Inventor: KIM, Sunghun, Suwon-si, Gyeonggi-do 16677 (KR); PARK, Seunghwa, Suwon-si, Gyeonggi-do 16677 (KR); LEE, Soohyun, Suwon-si, Gyeonggi-do 16677 (KR); LEE, Seunghwan, Suwon-si, Gyeonggi-do 16677 (KR)
(74) Representative: Appleyard Lees IP LLP
(86) International application number: PCT/KR2023/016762
(87) International publication number: WO 2024/091027

(57) **Abstract**

According to an exemplary embodiment disclosed herein, a foldable electronic device is provided. The foldable electronic device may include a first housing, a second housing, and a hinge module. The hinge module may connect the first housing and the second housing. The hinge module may include a first bracket, a second bracket, and an elastic body. The first bracket may be disposed in the first housing. The second bracket may be connected to the first bracket so as to be able to slide in a straight line with respect to the first bracket. The second bracket may be rotatably connected to the second housing through a shaft perpendicular to the straight line. The elastic body may be positioned between the first bracket and the second bracket. Various other embodiments may be possible.

## Description

### [Technical Field]

The disclosure relates to a foldable electronic device.

### [Background Art]

There is a cradle for wireless earphones (e.g., wireless earbuds). The cradle is a foldable electronic device, and wireless earphones may be stored in the cradle.

The above-described information may be provided as related art for the purpose of helping to understand the disclosure. No claim or determination is made as to whether any of the foregoing may be applied as prior art with respect to the disclosure.

### [Disclosure of Invention]

### [Technical Problem]

There is a risk that, due to external impacts, such as those caused by dropping, the cradle may open, and the wireless earphones may detach from the cradle and be lost.

Various embodiments of the disclosure provide a foldable electronic device (e.g., a cradle) capable of reducing or preventing opening due to external impacts.

The technical problems to be addressed by this disclosure are not limited to those described above, and other technical problems not mentioned above may be understood by a person ordinarily skilled in the related art to which the disclosure pertains.

### [Solution to Problem]

An exemplary embodiment of the disclosure provides a foldable electronic device that includes a first housing, a second housing, and a hinge module. The hinge module connects the first housing and the second housing. The hinge module includes a first bracket, a second bracket, and an elastic element. The first bracket is disposed in the first housing. The second bracket is connected to the first bracket to be slidable in a linear direction relative to the first bracket. The second bracket is rotatably connected to the second housing via a shaft perpendicular to the linear direction. The elastic element is positioned between the first bracket and the second bracket.

### [Advantageous Effects of Invention]

The foldable electronic device according to an exemplary embodiment of the disclosure may reduce or prevent opening in response to external impacts.

In addition, effects that may be obtained or predicted by various embodiments of the disclosure may be directly or implicitly disclosed in the detailed description of the embodiments of the disclosure.

### [Brief Description of Drawings]

The above and other aspects, features, and advantages of specific embodiments of the disclosure will become more apparent from the following detailed description taken in conjunction with the accompanying drawings.
FIG. 1 illustrates a foldable electronic device according to an embodiment of the disclosure in a folded state.
FIG. 2 is a perspective view of the foldable electronic device according to an embodiment of the disclosure in an unfolded state.
FIG. 3 is a perspective view illustrating the foldable electronic device in the unfolded state, along with a first wireless earphone and a second wireless earphone placed in the foldable electronic device, according to an embodiment of the disclosure.
FIG. 4 is an exploded perspective view illustrating the foldable electronic device according to an embodiment of the disclosure.
FIGS. 5, 6, 7, 8, and 9 are views illustrating combinations of components included in the foldable electronic device according to an embodiment of the disclosure.
FIG. 10 is a perspective view of a hinge module according to an embodiment of the disclosure.
FIGS. 11, 12, and 13 are views illustrating the hinge module according to an embodiment of the disclosure.
FIG. 14 is a cross-sectional view of the hinge module, taken along line F-F' in FIG. 11, according to an embodiment of the disclosure.
FIG. 15 is a cross-sectional view of the hinge module, taken along line G-G' in FIG. 11, according to an embodiment of the disclosure.
FIG. 16 is a cross-sectional view of the hinge module, taken along line H-H' of FIG. 11, according to an embodiment of the disclosure.
FIG. 17 is a cross-sectional view of the hinge module, taken along line I-I' of FIG. 11, according to an embodiment of the disclosure.
FIG. 18 illustrates a cross-sectional view of the foldable electronic device in a first folded state, taken along line C-C' of FIG. 7, and a cross-sectional view of the foldable electronic device in a second folded state, taken along line C-C' of FIG. 7, according to an embodiment of the disclosure.
FIG. 19 illustrates a cross-sectional view of the foldable electronic device in the second folded state, taken along line E-E' of FIG. 7, and a cross-sectional view of the foldable electronic device in the unfolded state, taken along line E-E' of FIG. 7, according to an embodiment of the disclosure.
FIG. 20 illustrates a cross-sectional perspective view of a portion of the foldable electronic device in the unfolded state, taken along line E-E' in FIG. 7, according to an embodiment of the disclosure.
FIG. 21 is a view illustrating a combination of multiple components included in the foldable electronic device according to an embodiment of the disclosure.
FIG. 22 is a view illustrating a second housing according to an embodiment of the disclosure.
FIG. 23 is a perspective view of the second housing according to an embodiment of the disclosure.
FIG. 24 is a perspective view illustrating the second housing, a first hook, and a second hook in the first folded state of the foldable electronic device according to an embodiment of the disclosure.
FIG. 25 is a perspective view illustrating the second housing, the first hook, and the second hook in the second folded state of the foldable electronic device according to an embodiment of the disclosure.
FIG. 26 is a cross-sectional view of the foldable electronic device in the first folded state, taken along line J-J' of FIG. 21, according to an embodiment of the disclosure.
FIG. 27 is a cross-sectional view of the foldable electronic device in the second folded state, taken along line J-J' of FIG. 21, according to an embodiment of the disclosure.
FIG. 28 illustrates a cross-sectional view of the foldable electronic device in a first folded state, taken along line E-E' of FIG. 7, and a cross-sectional view of the foldable electronic device in a second folded state, taken along line E-E' of FIG. 7, according to an embodiment of the disclosure.
FIG. 29 is a cross-sectional view of the foldable electronic device in the first folded state, taken along line E-E' of FIG. 7, according to an embodiment of the disclosure.
FIG. 30 is a cross-sectional view of the foldable electronic device in the second folded state, taken along line E-E' of FIG. 7, according to an embodiment of the disclosure.

### [Mode for the Invention]

Hereinafter, various exemplary embodiments of the disclosure will be described in more detail with reference to the accompanying drawings.

Various embodiments of the disclosure and the terms used therein do not limit features described in the disclosure to specific embodiments. In connection with the description of the drawings, similar or related components may be indicated by similar reference numerals. The singular form of a noun corresponding to an item may include one or more items unless the relevant context clearly indicates otherwise. In the disclosure, each of phrases, such as "A or B," "at least one of A and B," "at least one of A or B," "A, B, or C," "at least one of A, B, and C," and "at least one of A, B, or C," may include any one of the items listed together in the corresponding phrase or all possible combinations of the items. Terms such as "1^{st}," "2^{nd}," "first," or "second" may be used simply to distinguish corresponding components from other components, and the components are not limited in other respects (e.g., importance or order). When one component (e.g., a first component) is mentioned as being "coupled" or "connected" to another component (e.g., a second component), with or without a term "functionally" or "communicatively," it means that the one component may be connected to the other component directly (e.g., wiredly), wirelessly, or via a third component.

The term "module" may refer to an integrally configured component or the smallest unit or part of a component that performs one or more functions.

Each of components (e.g., modules) may include a single entity or multiple entities. One or more of the aforementioned components may be omitted, or one or more other components may be added. Alternatively or additionally, multiple components (e.g., modules) may be integrated into a single component. In such a case, the integrated component may perform one or more functions of each of the plurality of components in the same or similar manner as being performed by the corresponding one of the plurality of components prior to the integration.

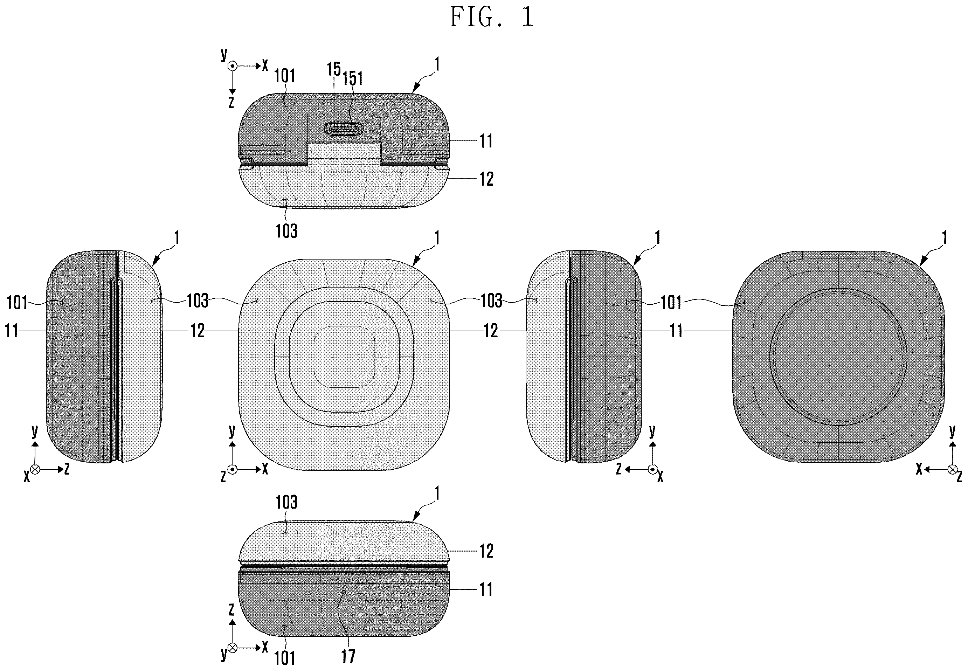

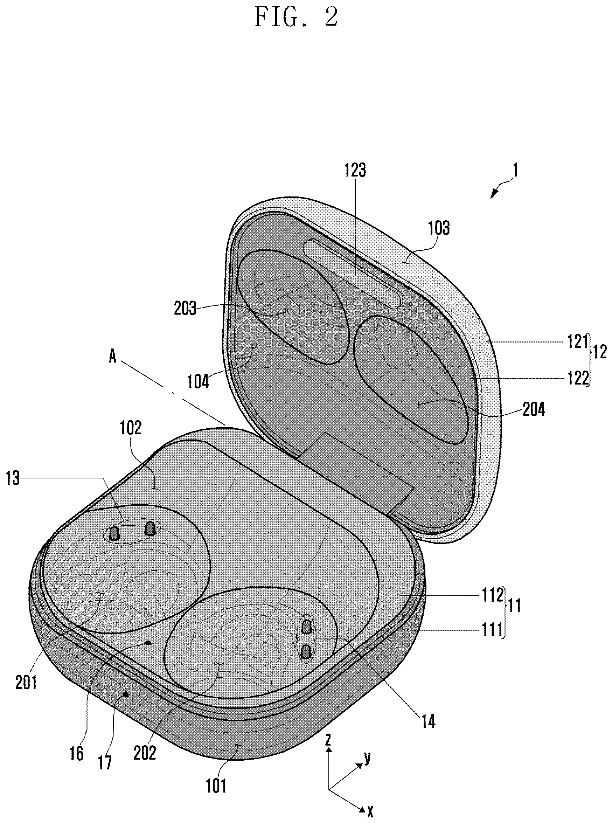

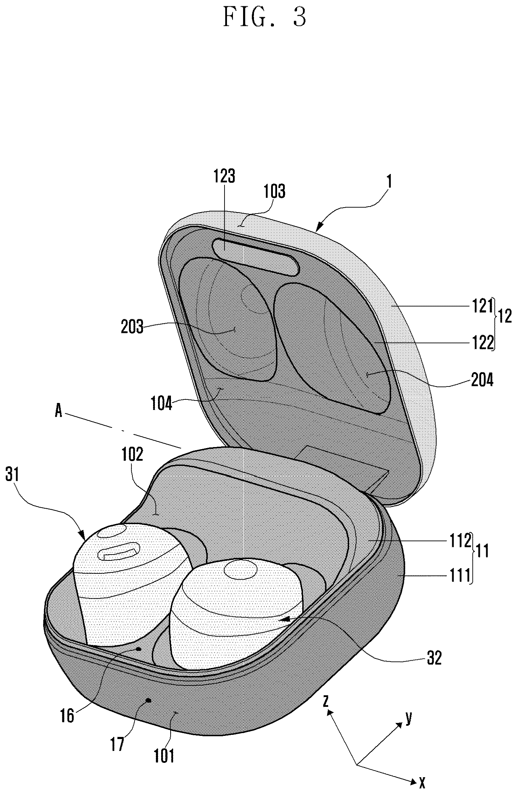

FIG. 1 illustrates a foldable electronic device (e.g., a cradle) 1 in a folded state according to an embodiment of the disclosure. FIG. 2 is a perspective view of the foldable electronic device 1 according to an embodiment of the disclosure in an unfolded state. FIG. 3 is a perspective view of the foldable electronic device 1 in the unfolded state, along with a first wireless earphone 31 and a second wireless earphone 32 placed in the foldable electronic device 1, according to an embodiment of the disclosure.

Referring to FIGS. 1, 2, and 3, the foldable electronic device 1 may include a foldable housing 10, a first connection terminal (or first interface terminal) 13, a second connection terminal (or second interface terminal) 14, and/or a third connection terminal (or third interface terminal) 15.

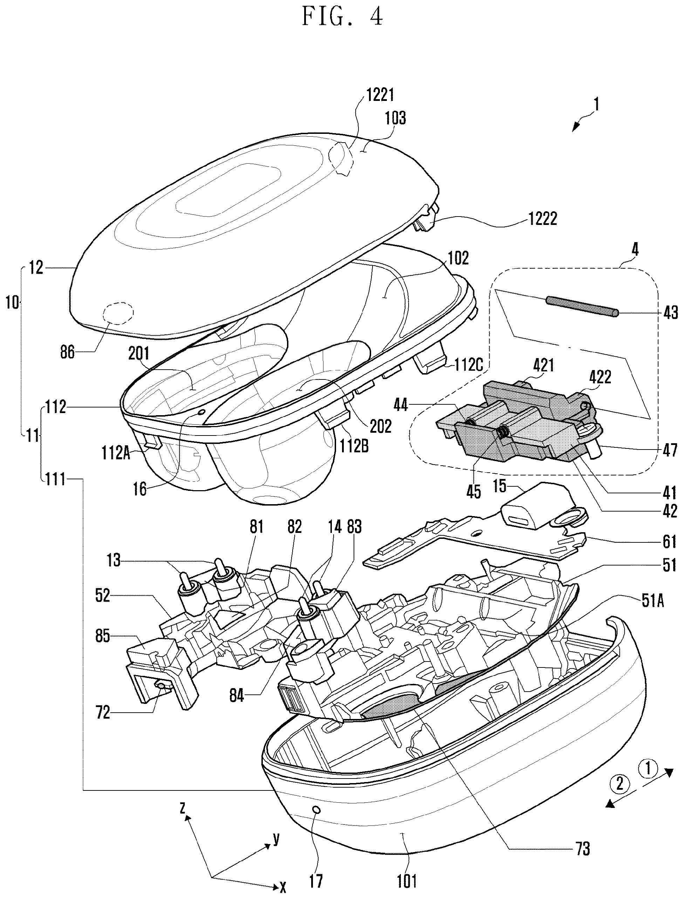

According to an embodiment, the foldable housing 10 may include a first housing (or first housing portion or first housing structure) 11, a second housing (or second housing portion or second housing structure) 12, and a hinge module (e.g., the hinge module 4 in FIG. 4). The first housing 11 and the second housing 12 may be connected via the hinge module. The first housing 11 and the second housing 12 may rotate relative to each other about a folding axis A provided by the hinge module. The folding axis A may be defined or interpreted as an imaginary straight line that serves as the center of rotation when the second housing 12 rotates relative to the first housing 11.

According to an embodiment, the first housing 11 may include a first surface 101 and a second surface 102. The second housing 12 may include a third surface 103 and a fourth surface 104. In the folded state of the foldable electronic device 1, the outer surface of the foldable electronic device 1 may be substantially provided by the combination of the first surface 101 and the third surface 103. In the folded state of the foldable electronic device 1, the second surface 102 and the fourth surface 104 may face each other. In the folded state of the foldable electronic device 1, the second surface 102 and the fourth surface 104 may not be visible from the exterior of the foldable electronic device 1.

According to an embodiment, in the folded state of the foldable electronic device 1, a portion of the first surface 101 included in the first housing 11 may provide the rear surface of the foldable electronic device 1. In the folded state of the foldable electronic device 1, a portion of the third surface 103 included in the second housing 12 may provide the front surface of the foldable electronic device 1. In the folded state of the foldable electronic device 1, a combination of a portion of the first surface 101 included in the first housing 11 and a portion of the third surface 103 included in the second housing 12 may provide a side surface of the foldable electronic device 1. In the folded state of the foldable electronic device 1, a portion of the first surface 101 included in the first housing 11 may provide a portion of the side surface of the foldable electronic device 1 that is closer to the rear surface of the foldable electronic device 1. In the folded state of the foldable electronic device 1, a portion of the third surface 103 included in the second housing 12 may provide a portion of the side surface of the foldable electronic device 1 that is closer to the front surface of the foldable electronic device 1.

The illustrated coordinate axes are provided with reference to the first housing 11. The direction in which the rear surface of the foldable electronic device 1 is oriented may be defined as the -z axis direction.

According to an embodiment, the second housing 12 may include a flexible member 123 disposed on or coupled to the fourth surface 104. When the foldable electronic device 1 is switched from the unfolded state to the folded state, the flexible member 123 may mitigate impact between the first housing 11 and the second housing 12. The flexible member 123 may include a cushioning material.

According to an embodiment, in the folded state of the foldable electronic device 1, a combination of the second surface 102 of the first housing 11 and the fourth surface 104 of the second housing 12 may provide a first space (not separately illustrated) capable of accommodating a first wireless earphone 31, and a second space (not separately shown) capable of accommodating a second wireless earphone 32. In the folded state of the foldable electronic device 1, the first space may be provided to allow the first wireless earphone 31 to be stably positioned between the first housing 11 and the second housing 12. In the folded state of the foldable electronic device 1, the second space may be provided to allow the second wireless earphone 32 to be stably positioned between the first housing 11 and the second housing 12.

According to various embodiments, the term "wireless earphone" may be replaced with the term "wireless earbud" or the term "ear wearable wireless device."

According to an embodiment, the second surface 102 of the first housing 11 may include a first recess 201 and a second recess 202. The fourth surface 104 of the second housing 12 may include a third recess 203 and a fourth recess 204. In the folded state of the foldable electronic device 1, a combination of the first recess 201 and the third recess 203 may provide a first space configured to accommodate the first wireless earphone 31. The first recess 201 may provide a sub-space within the first space where a portion of the first wireless earphone 31 may be substantially fitted. The third recess 203 may provide a sub-space within the first space configured to accommodate the remaining portion of the first wireless earphone 31. In the folded state of the foldable electronic device 1, a combination of the second recess 202 and the fourth recess 204 may provide a second space configured to accommodate the second wireless earphone 32. The second recess 202 may provide a sub-space within the second space where a portion of the second wireless earphone 32 may be substantially fitted. The fourth recess 204 may provide a sub-space within the second space configured to accommodate the remaining portion of the second wireless earphone 32.

According to an embodiment, the first housing 11 may include a first cover 111 and a second cover 112. The first cover 111 may provide the first surface 101. The second cover 112 may provide the second surface 102. The first cover 111 and the second cover 112 may be coupled through various methods, including screw fastening, snap-fit (e.g., a fastening method including a hook and a hook fastening portion), bonding with adhesive material (or adhesive substance), or a combination of at least two of these methods. The first cover 111 and the second cover 112 may also be coupled through other various methods.

According to an embodiment, the first cover 111 and the second cover 112 may include the same material or different materials.

According to an embodiment, the second housing 12 may include a third cover 121 and a fourth cover 122. The third cover 121 may provide the third surface 103. The fourth cover 122 may provide the fourth surface 104. The third cover 121 and the fourth cover 122 may be coupled through various methods, including screw fastening, snap-fit, bonding with adhesive material (or adhesive substance), or a combination of at least two of these methods. The third cover 121 and the fourth cover 122 may also be coupled through other various methods.

According to an embodiment, the third cover 121 and the fourth cover 122 may include the same material or different materials.

According to various embodiments, an integral cover replacing the third cover 121 and the fourth cover 122 may be provided.

According to an embodiment, when the foldable electronic device 1 is switched from the folded state to the unfolded state, the maximum angle at which the second housing 12 opens relative to the first housing 11 may be constrained by interference between the first housing 11 and the hinge module (e.g., the hinge module 4 in FIG. 4), between the second housing 12 and the hinge module, or between the first housing 11 and the second housing 12.

According to an embodiment, when the first wireless earphone 31 is placed in the first recess 201 of the first housing 11, the first wireless earphone 31 may be electrically connected to the foldable electronic device 1 via the first connection terminal 13. When the second wireless earphone 32 is placed in the second recess 202 of the first housing 11, the second wireless earphone 32 may be electrically connected to the foldable electronic device 1 via the second connection terminal 14.

According to an embodiment, the foldable electronic device 1 may provide power received from an external electronic device (not separately illustrated) to the first wireless earphone 31 via the first connection terminal 13. The foldable electronic device 1 may charge a first battery (not separately illustrated) included in the first wireless earphone 31 using power received from an external electronic device (not separately illustrated).

According to an embodiment, the foldable electronic device 1 may provide power received from an external electronic device (not separately illustrated) to the second wireless earphone 32 via the second connection terminal 14. The foldable electronic device 1 may charge a second battery (not separately illustrated) included in the second wireless earphone 32 using power received from an external electronic device (not separately illustrated).

According to an embodiment, the first connection terminal 13 may be positioned in the first housing 11 to correspond to the first recess 201 of the first housing 11. When the first wireless earphone 31 is placed in the first recess 201 of the first housing 11, a connection terminal (not separately illustrated) of the first wireless earphone 31 may come into physical contact with the first connection terminal 13 of the foldable electronic device 1. The second connection terminal 14 may be positioned in the first housing 11 to correspond to the second recess 202. When the second wireless earphone 32 is placed in the second recess 202 of the first housing 11, a connection terminal (not separately illustrated) of the second wireless earphone 32 may come into physical contact with the second connection terminal 14 of the foldable electronic device 1.

According to an embodiment, the first connection terminal 13 may include one or more first pogo pins, and the second connection terminal 14 may include one or more second pogo pins. The one or more first pogo pins may come into elastic contact with a connection terminal (not separately illustrated) of the first wireless earphone 31 placed in the first recess 201 of the first housing 11. The one or more second pogo pins may come into elastic contact with a connection terminal (not separately illustrated) of the second wireless earphone 32 placed in the second recess 202 of the first housing 11. The first connection terminal 13 or the second connection terminal 14 may be implemented using other various available conductive members.

According to an embodiment, when the first wireless earphone 31 is positioned in the first recess 201 of the first housing 11, an attractive force between magnetic elements may be provided to pull the first wireless earphone 31 into the first recess 201. When the first wireless earphone 31 is positioned in the first recess 201 of the first housing 11, an attractive force may be provided between one or more magnetic elements (not separately illustrated) accommodated in the first housing 11 to correspond to the first recess 201 and one or more magnetic elements (not separately illustrated) included in the first wireless earphone 31.

According to an embodiment, when the second wireless earphone 32 is positioned in the second recess 202 of the first housing 11, an attractive force between magnetic elements may be provided to pull the second wireless earphone 32 into the second recess 202. When the second wireless earphone 32 is positioned in the second recess 202 of the first housing 11, an attractive force may be provided between one or more magnetic elements (not separately illustrated) accommodated in the first housing 11 to correspond to the second recess 202 and one or more magnetic elements (not separately illustrated) included in the second wireless earphone 32.

According to an embodiment, the third connection terminal 15 may include a connector positioned to correspond to a connector hole 151 provided in the first cover 111 of the first housing 11. The connector may include, for example, a universal serial bus (USB) connector. The positions or number of third connection terminals 15 and connector holes 151 corresponding to the third connection terminals 15 are not limited to the illustrated example and may vary.

According to an embodiment, the foldable electronic device 1 may transmit and/or receive power and/or data to and/or from an external electronic device (not separately illustrated) electrically connected to the third connection terminal 15.

According to various embodiments, the foldable electronic device 1 may support data communication between an external electronic device (not separately illustrated) electrically connected to the third connection terminal 15 and the first wireless earphone 31 electrically connected to the first connection terminal 13. The foldable electronic device 1 may support data communication between an external electronic device (not separately illustrated) electrically connected to the third connection terminal 15 and the second wireless earphone 32 electrically connected to the second connection terminal 14.

According to an embodiment, the foldable electronic device 1 may include a first light-emitting module (e.g., the first light-emitting module 71 in FIG. 4) positioned in the inner space of the foldable housing 10 to correspond to (or in alignment with) a first light-transmitting area 16 provided on the exterior of the foldable housing 10. Light emitted from the first light-emitting module may be visually perceivable through the first light-transmitting area 16. The first light-emitting module may include various light sources, such as, a light-emitting diode (LED), an infrared (IR), or a xenon lamp.

According to an embodiment, the foldable electronic device 1 may visually provide status information of the first wireless earphone 31 and/or the second wireless earphone 32 disposed in the foldable electronic device 1 through the first light-emitting module (e.g., the first light-emitting module 71 in FIG. 4) to correspond to the first light-transmitting area 16.

According to an embodiment, the second cover 112 of the first housing 11 may include the first light-transmitting area 16. The first light-transmitting area 16 may be positioned on the second surface 102. The first light-transmitting area 16 may be positioned around the first recess 201 and the second recess 202 of the second surface 102. The positions or number of first light-transmitting areas 16 and first light-emitting modules (e.g., the first light-emitting module 71 in FIG. 4) corresponding to the first light-transmitting areas 16 are not limited to the illustrated example and may vary.

According to an embodiment, the foldable electronic device 1 may include a second light-emitting module (e.g., the second light-emitting module 72 in FIG. 4) positioned in the inner space of the foldable housing 10 to correspond to (or in alignment with) a second light-transmitting area 17 provided on the exterior of the foldable housing 10. Light emitted from the second light-emitting module may be visually perceivable through the second light-transmitting area 17. The second light-emitting module may include various light sources, such as an LED, IR, or xenon lamp.

According to an embodiment, the foldable electronic device 1 may visually provide status information of the foldable electronic device 1 through the second light-emitting module (e.g., the second light-emitting module 72 in FIG. 4) corresponding to the second light-transmitting area 17.

According to an embodiment, the first cover 111 of the first housing 11 may include the second light-transmitting area 17. The second light-transmitting area 17 may be positioned on a side surface of the foldable electronic device 1. The positions or number of second light-transmitting areas 17 and second light-emitting modules (e.g., the second light-emitting module 72 in FIG. 4) corresponding to the second light-transmitting areas 17 are not limited to the illustrated example and may vary.

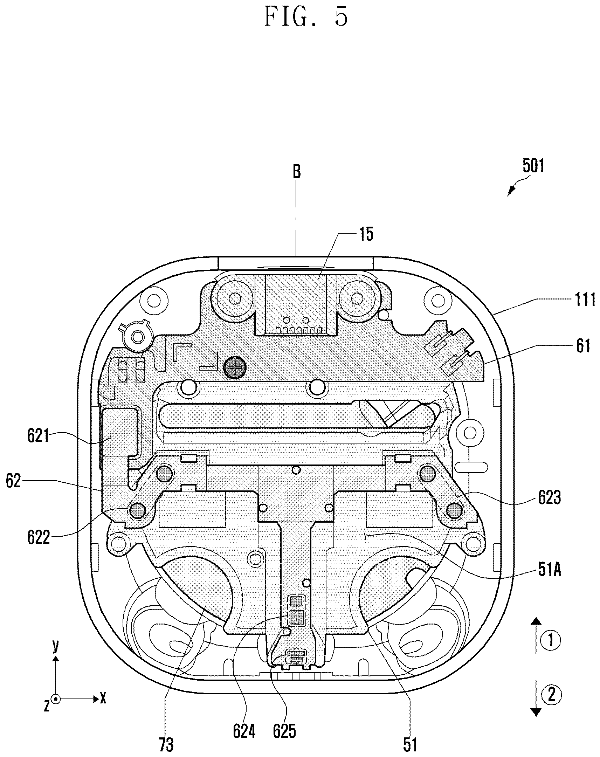

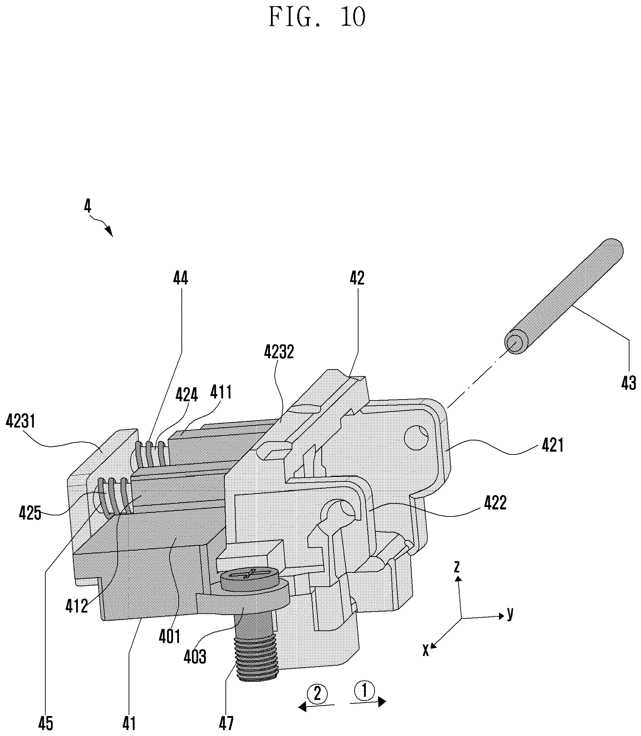

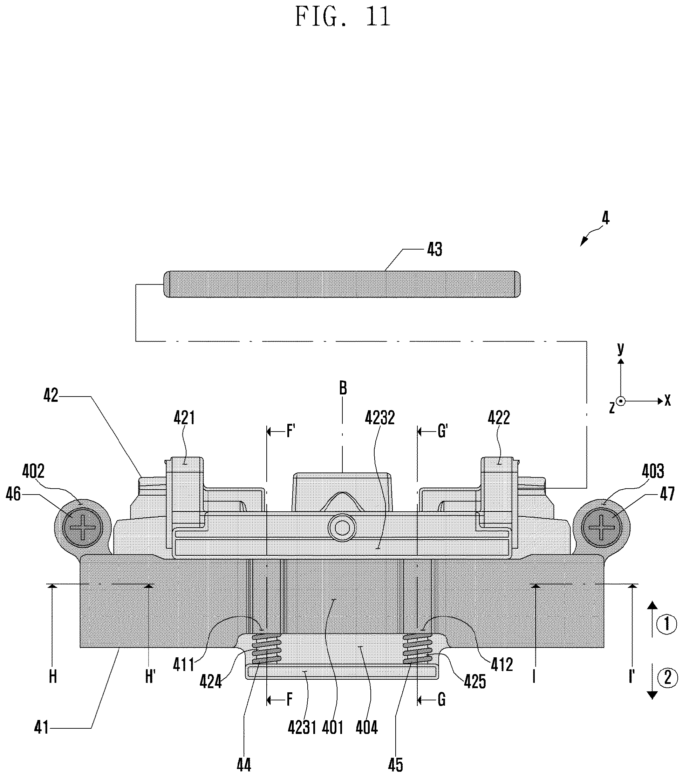

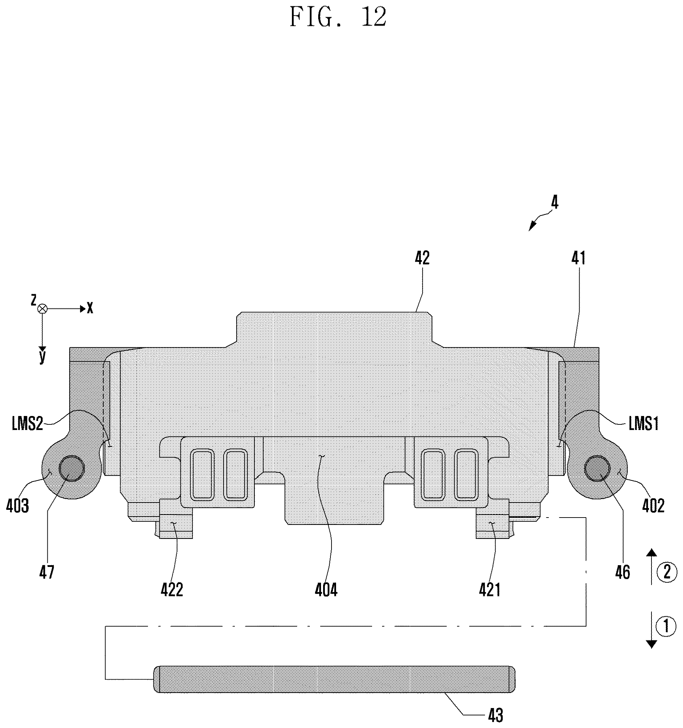

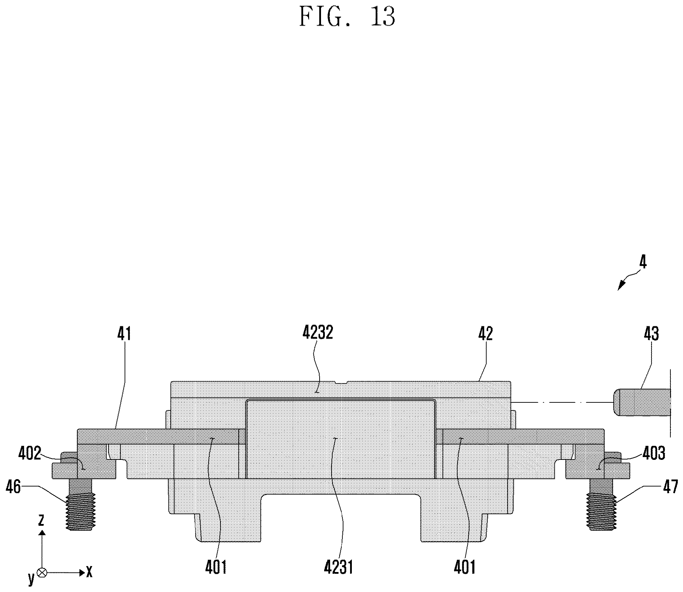

FIG. 4 is an exploded perspective view of a foldable electronic device 1 according to an embodiment of the disclosure. FIGS. 5, 6, 7, 8, and 9 are views illustrating combinations of components included in the foldable electronic device 1 according to an embodiment of the disclosure. FIG. 10 is a perspective view of a hinge module 4 according to an embodiment of the disclosure. FIGS. 11, 12, and 13 are views illustrating the hinge module 4 according to an embodiment of the disclosure.

Referring to FIGS. 4, 5, 6, 7, 8, 9, 10, 11, 12, and 13, the foldable electronic device 1 may include a first housing 11, a second housing 12, a hinge module 4, a first support 51, a second support 52, a first printed circuit board 61, a second printed circuit board 62, a first connection terminal 13, a second connection terminal 14, a third connection terminal 15, a first light-emitting module 71, a second light-emitting module 72, an antenna structure 73, a first magnetic element 81, a second magnetic element 82, a third magnetic element 83, a fourth magnetic element 84, a fifth magnetic element 85, and/or a sixth magnetic element 86.

According to an embodiment, FIG. 5 is a view illustrating a first combination 501 of multiple components included in the foldable electronic device 1. The first combination 501 may include the first cover 111, the first support 51, the first printed circuit board 61, the second printed circuit board 62, the third connection terminal 15, and the antenna structure 73.

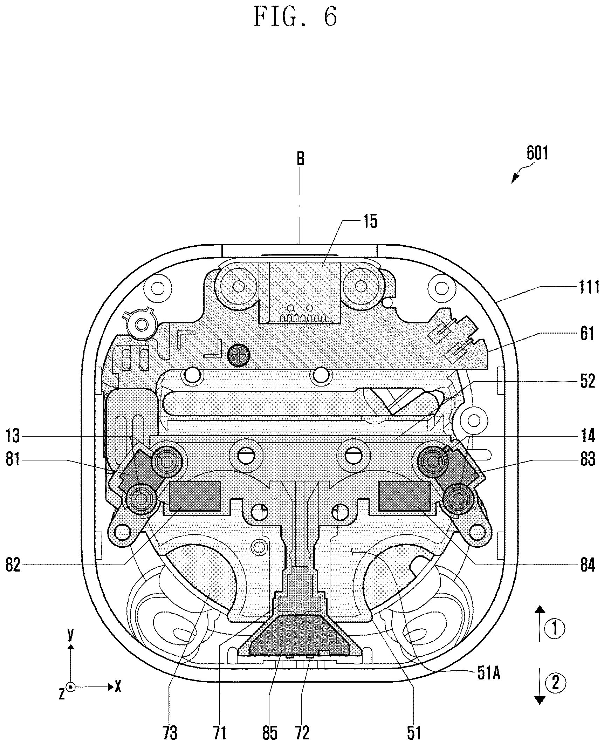

According to an embodiment, FIG. 6 is a view illustrating a second combination 601 of multiple components included in the foldable electronic device 1. The second combination 601 may include the first combination 501, the second support 52, the first connection terminal 13, the second connection terminal 14, the first magnetic element 81, the second magnetic element 82, the third magnetic element 83, the fourth magnetic element 84, and the fifth magnetic element 85.

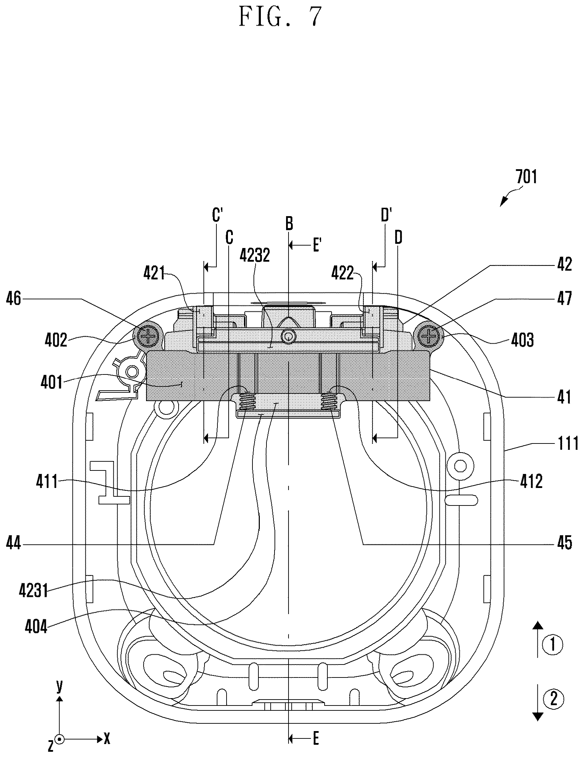

According to an embodiment, FIG. 7 is a view illustrating a third combination 701 of multiple components included in the foldable electronic device 1. The third combination 701 may include the first cover 111, the first bracket 41, the second bracket 42, the first elastic element 44, the second elastic member 45, the first screw 46, and the second screw 47.

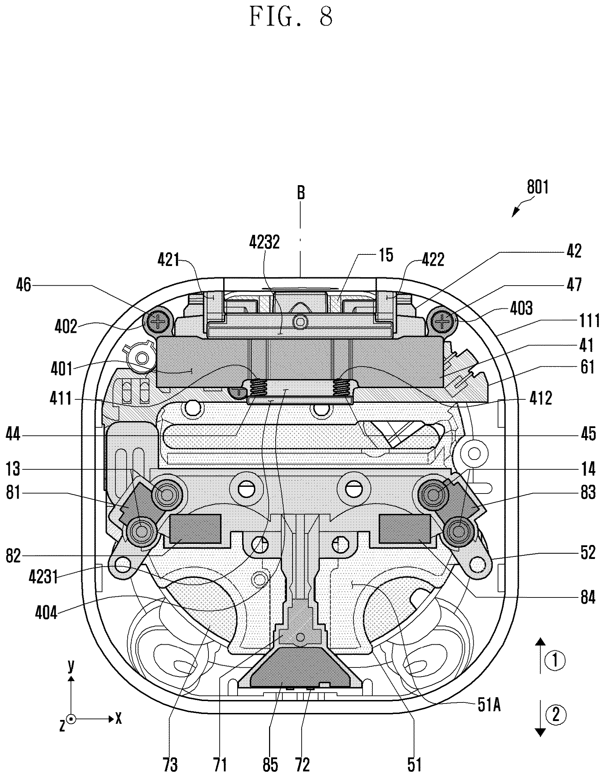

According to an embodiment, FIG. 8 is a view illustrating a fourth combination 801 of multiple components included in the foldable electronic device 1. The fourth combination 801 may include the second combination 601, the first bracket 41, the second bracket 42, the first elastic element 44, the second elastic member 45, the first screw 46, and the second screw 47.

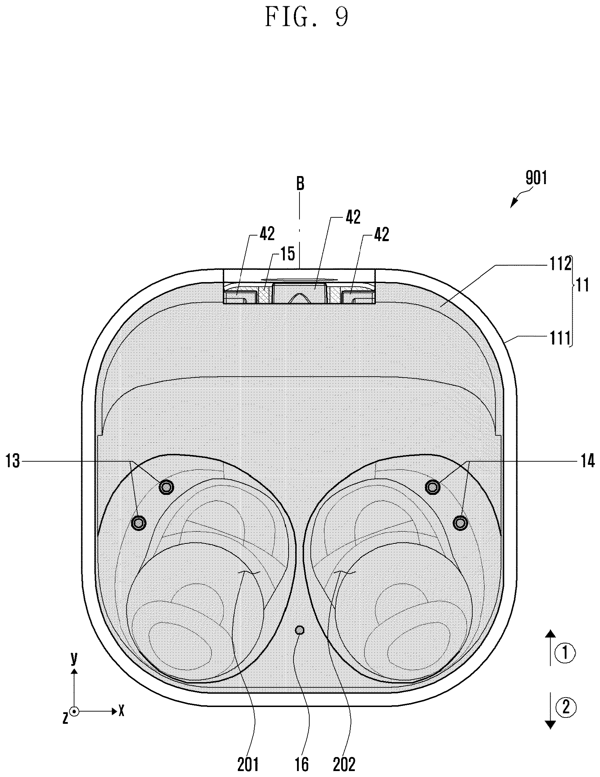

According to an embodiment, FIG. 9 is a view illustrating a fifth combination 901 of multiple components included in the foldable electronic device 1. The fifth combination 901 may include the fourth combination 801 and the first cover 111.

According to an embodiment, the first housing 11 may include a first cover 111 and a second cover 112. The first cover 111 may provide the first surface 101 of the foldable electronic device 1. The first cover 111 may include a first light-transmitting area 16 corresponding to the first light-emitting module 71. The second cover 112 may provide the second surface 102 of the foldable electronic device 1. The second cover 112 may include a first recess 201 corresponding to the first wireless earphone 31 (see FIG. 3) and a second recess 202 corresponding to the second wireless earphone 32 (see FIG. 3). The second cover 112 may include a second light-transmitting area 17 corresponding to the second light-emitting module 72.

According to an embodiment, the first cover 111 and the second cover 112 may be coupled through snap-fit. The second cover 112 may include multiple hooks 112A, 112B, and 112C, and the second cover 112 may include multiple hook fastening portions (e.g., multiple hook engagement portions) (not separately illustrated) corresponding to the multiple hooks 112A, 112B, and 112C.

According to various embodiments, the first cover 111 and the second cover 112 may be coupled via one or more screws (not separately illustrated).

According to an embodiment, the first support 51, the second support 52, the first printed circuit board 61, the second printed circuit board 62, the first connection terminal 13, the second connection terminal 14, the third connection terminal 15, the first light-emitting module 71, the second light-emitting module 72, the antenna structure 73, the first magnetic element 81, the second magnetic element 82, the third magnetic element 83, the fourth magnetic element 84, and the fifth magnetic element 85 may be disposed in the inner space of the first housing 11 provided by the combination of the first cover 111 and the second cover 112.

According to an embodiment, the hinge module 4 may include a first bracket 41, a second bracket 42, a shaft 43, a first elastic element (or first elastic member) 44, a second elastic element (or second elastic member) 45, a first screw 46, and/or a second screw 47.

According to an embodiment, the first bracket 41 may be coupled to the first cover 111 of the first housing 11.

According to an embodiment, the first bracket 41 may be coupled to the first cover 111 of the first housing 11 via the first screw 46 and the second screw 47. The first bracket 41 may include a first screw hole corresponding to the first screw 46 and a second screw hole corresponding to the second screw 47. The first cover 111 of the first housing 11 may include a first screw fastening portion (not separately illustrated) aligned with the first screw hole and a second screw fastening portion (not separately illustrated) aligned with the second screw hole. The screw fastening portions may be bosses including female threads corresponding to male threads of screws.

According to an embodiment, the first bracket 41 may include a first portion 401, a second portion 402, and/or a third portion 403. When viewed from above the first cover 111 (e.g., viewed in the -z-axis direction), the first portion 401 may overlap the second bracket 42. The second bracket 42 may be slidably connected to the first portion 401. The second portion 402 and the third portion 403 may extend from the first portion 401. The second portion 402 may include the first screw hole corresponding to the first screw 46. The third portion 403 may include the second screw hole corresponding to the second screw 47.

According to an embodiment, the first bracket 41 may be provided in a substantially symmetric shape with respect to the centerline B of the hinge module 4, which is perpendicular to the folding axis A (or the shaft 43) of the foldable housing 10 (or the foldable electronic device 1). The first portion 401 may be provided in a substantially symmetric shape with respect to the centerline B of the hinge module 4. The second portion 402 and the third portion 403 may be provided to be substantially symmetric to each other with respect to the centerline B of the hinge module 4. In various embodiments, the first bracket 41 may be provided in various other forms (not separately illustrated).

According to an embodiment, the second bracket 42 may be connected to the second housing 12 via the shaft 43.

According to an embodiment, the shaft 43 may be provided in the form of a cylinder extending from a first end portion to a second end portion in the direction of the folding axis A (e.g., the x-axis direction) of the foldable housing 10 (or the foldable electronic device 1). The shaft 43 may be, for example, a metal pin. The shaft 43 may have axial stiffness sufficient to ensure durability for the relative rotational motion between the second housing 12 and the second bracket 42 of the hinge module 4.

According to an embodiment, the folding axis A of the foldable housing 10 (or the foldable electronic device 1) may substantially correspond to the central axis of the shaft 43 of the hinge module 4. In various embodiments, the folding axis A may be defined or interpreted as the shaft 43 of the hinge module 4.

According to an embodiment, the second bracket 42 may include a first shaft support 421 and a second shaft support 422. The first shaft support 421 and the second shaft support 422 may be spaced apart from each other in the direction of the folding axis A (e.g., the x-axis direction) of the foldable housing 10 (or the foldable electronic device 1). The first shaft support 421 and the second shaft support 422 may be connected to the second housing 12 via the shaft 43. The first shaft support 421 may include a first shaft hole, and the second shaft support 422 may include a second shaft hole. The shaft 43 may be positioned in the first shaft hole and the second shaft hole.

According to an embodiment, the second housing 12 may include a third shaft support 1221 and a fourth shaft support 1222. The third shaft support 1221 and the fourth shaft support 1222 may be spaced apart from each other in the direction of the folding axis A (e.g., the x-axis direction) of the foldable housing 10 (or the foldable electronic device 1). The third shaft support 1221 and the fourth shaft support 1222 may be connected to the second bracket 42 of the hinge module 4 via the shaft 43. The third shaft support 1221 may include a third shaft hole, and the fourth shaft support 1222 may include a fourth shaft hole. The shaft 43 may be positioned in the third shaft hole and the fourth shaft hole.

According to an embodiment, the third shaft support 1221 and the fourth shaft support 1222 of the second housing 12 may be positioned between the first shaft support 421 and the second shaft support 422 of the second bracket 42. The third shaft support 1221 may be positioned between the first shaft support 421 and the fourth shaft support 1222. The fourth shaft support 1222 may be positioned between the third shaft support 1221 and the second shaft support 422.

According to an embodiment, the second bracket 42 may include a fourth portion 404. The first shaft support 421 and the second shaft support 422 may extend from the fourth portion 404. When viewed from above the first cover 111 (e.g., viewed in the -z-axis direction), the fourth portion 404 may overlap the first portion 401 of the first bracket 41.

According to an embodiment, the second bracket 42 may be provided in a substantially symmetric shape with respect to the centerline B of the hinge module 4. The fourth portion 404 may be provided in a substantially symmetric shape with respect to the centerline B of the hinge module 4. The first shaft support 421 and the second shaft support 422 may be provided to be substantially symmetric to each other with respect to the centerline B of the hinge module 4.

According to an embodiment, the second bracket 42 may be connected to the first bracket 41 to be slidable in a linear direction relative to the first bracket 41. The second bracket 42 may be capable of linear motion (or translational motion) relative to the first bracket 41 in the direction of the centerline B of the hinge module 4.

According to an embodiment, the second bracket 42 may include a first support wall 4231 and a second support wall 4232. The first support wall 4231 and the second support wall 4232 may extend from the fourth portion 404. The first support wall 4231 and the second support wall 4232 may be spaced apart in a direction perpendicular to the folding axis A (e.g., the y-axis direction) of the foldable housing 10 (or the foldable electronic device 1). The second support wall 4232 may be positioned between the first support wall 4231 and the shaft 43. The second bracket 42 may have a space provided by the combination of the fourth portion 404, the first support wall 4231, and the second support wall 4232. A portion included the first portion 401 of the first bracket 41 may be positioned in the space. Since a portion included in the first portion 401 of the first bracket 41 is positioned between the first support wall 4231 and the second support wall 4232 of the second bracket 42, the range of mutual sliding between the first bracket 41 and the second bracket 42 may be constrained.

According to an embodiment, the first elastic element 44 and the second elastic element 45 may be positioned between the first bracket 41 and the second bracket 42. The first elastic element 44 and the second elastic element 45 may provide elasticity for the linear motion (or translational motion) of the second bracket 42 relative to the first bracket 41.

According to an embodiment, the first elastic element 44 and the second elastic element 45 may be disposed at positions symmetrical to each other with respect to the centerline B of the hinge module 4.

According to an embodiment, depending on the relative position between the first bracket 41 and the second bracket 42, the elasticity provided by the first elastic element 44 and the elasticity provided by the second elastic element 45 may be substantially identical. The first elastic element 44 and the second elastic element 45 may be substantially the same type of elastic element.

According to an embodiment, based on the first elastic element 44 and the second elastic element 45, which provide elasticity between the first bracket 41 and the second bracket 42, one or more components of the hinge module 4 may be implemented to enable stable and balanced linear motion (or translational motion) of the second housing 12 connected to the second bracket 42 relative to the first housing 11 connected to the first bracket 41.

According to an embodiment, the first bracket 41 may include a first elastic element support 411 and a second elastic element support 412. The first elastic element support 411 and the second elastic element support 412 may extend from, or be connected to, the first portion 401. The first elastic element support 411 and the second elastic element support 412 may be positioned between the first support wall 4231 and the second support wall 4232 of the second bracket 42. The first elastic element support 411 may be provided in a form protruding from the first portion 401 to correspond to the first elastic element 44 and the first support wall 4231 of the second bracket 42. The second elastic element support 412 may be provided in a form protruding from the first portion 401 to correspond to the second elastic element 45 and the first support wall 4231 of the second bracket 42. The first elastic element 44 may be disposed between the first elastic element support 411 of the first bracket 41 and the first support wall 4231 of the second bracket 42. The second elastic element 45 may be disposed between the second elastic element support 412 of the first bracket 41 and the first support wall 4231 of the second bracket 42.

According to various embodiments, the first elastic element support 411 and the second elastic element support 412 may be interpreted as a portion of the first portion 401.

According to an embodiment, the folded state of the foldable electronic device 1 (or the foldable housing 10) may include a first folded state and a second folded state, depending on the relative position between the first bracket 41 and the second bracket 42.

According to an embodiment, the first folded state may correspond to a state in which the elastic element supports (e.g., the first elastic element support 411 and the second elastic element support 412) of the first bracket 41 and the first support wall 4231 of the second bracket 42 are spaced apart from each other by a substantially maximum first distance in the direction of the centerline B of the hinge module 4 (e.g., the y-axis direction). The second folded state may correspond to a state in which the elastic element supports (e.g., the first elastic element support 411 and the second elastic element support 412) of the first bracket 41 and the first support wall 4231 of the second bracket 42 are spaced apart from each other by a minimum second distance, or a second distance smaller than the first distance, in the direction of the centerline B of the hinge module 4 (e.g., the y-axis direction).

According to an embodiment, when an external force is applied to linearly move the second housing 12 in a first direction ① (e.g., the +y-axis direction) relative to the first housing 11, the second bracket 42 connected to the second housing 12 may linearly move in the first direction ① relative to the first bracket 41 connected to the first housing 11, and the foldable electronic device 1 may be switched from the first folded state to the second folded state.

According to an embodiment, when the second bracket 42 linearly moves in a second direction ② (e.g., the -y-axis direction) opposite to the first direction ①, relative to the first bracket 41 due to the elasticity of the first elastic element 44 and the elasticity of the second elastic element 45, the second housing 12 connected to the second bracket 42 may linearly move in the second direction ② relative to the first housing 11 connected to the first bracket 41, and the foldable electronic device 1 may be switched from the second folded state to the first folded state.

According to an embodiment, the elasticity of the first elastic element 44 and the elasticity of the second elastic element 45 may provide a retaining force that maintains the first housing 11 and the second housing 12 in a relative positional relationship corresponding to the first folded state.

According to an embodiment, in the first folded state, the distance between the first elastic element support 411 of the first bracket 41 and the first support wall 4231 of the second bracket 42 may be greater than that in the second folded state, and the first elastic element 44 may be less compressed or substantially uncompressed compared to its state in the second folded state. In the first folded state, the distance between the second elastic element support 412 of the first bracket 41 and the first support wall 4231 of the second bracket 42 may be greater than that in the second folded state, and the second elastic element 45 may be less compressed or substantially uncompressed compared to its state in the second folded state. In the second folded state, the distance between the first elastic element support 411 of the first bracket 41 and the first support wall 4231 of the second bracket 42 may be smaller than that in the first folded state, and the first elastic element 44 may be in a more compressed state compared to its state in the first folded state. In the second folded state, the distance between the second elastic element support 412 of the first bracket 41 and the first support wall 4231 of the second bracket 42 may be smaller than that in the first folded state, and the second elastic element 45 may be in a more compressed state compared to its state in the first folded state.

According to an embodiment, the first elastic element 44 may be a first coil compression spring, and the second elastic element 45 may be a second coil compression spring. The second bracket 42 may include a first protrusion 424 extending in the first direction ① from the first support wall 4231. The second bracket 42 may include a second protrusion 425 extending in the first direction ① from the first support wall 4231. The first protrusion 424 may be inserted into the central space of the first coil compression spring. The second protrusion 425 may be inserted into the central space of the second coil compression spring. The first protrusion 424 may reduce or prevent the first coil compression spring from detaching from the space between the first elastic element support 411 of the first bracket 41 and the first support wall 4231 of the second bracket 42. The second protrusion 425 may reduce or prevent the second coil compression spring from detaching from the space between the second elastic element support 412 of the first bracket 41 and the first support wall 4231 of the second bracket 42.

According to various embodiments, the first elastic element 44 or the second elastic element 45 is not limited to coil compression springs, and may be implemented in various other types of elastic elements (e.g., a flexible member like rubber, or various other types of springs). Depending on the types of the elastic elements, the first protrusion 424 and the second protrusion 425 may be omitted.

According to various embodiments, an integrated elastic element (e.g., a flexible member such as rubber or various other types of springs) that replaces the first elastic element 44 and the second elastic element 45 may be implemented. Depending on the types of the elastic elements, the first protrusion 424 and the second protrusion 425 may be omitted.

According to an embodiment, the first support 51 may be disposed or coupled to the first cover 111 of the first housing 11.

According to an embodiment, the first support 51 may be disposed or coupled to the first cover 111 of the first housing 11 through screw fastening, snap-fit, various other methods, or a combination of at least two of these methods.

According to an embodiment, the first support 51 may include a first support surface (or first support area) 51A and a second support surface (or second support area) (not separately illustrated). In the folded state of the foldable electronic device 1, the first support surface 51A may face the front surface of the foldable electronic device 1, and the second support surface may face the rear surface of the foldable electronic device 1.

According to an embodiment, when viewed from above the second cover 112 of the first housing 11 (e.g., in the -z-axis direction), the hinge module 4 may overlap the first support 51. A portion of the first support 51 may be positioned between the hinge module 4 and the first cover 111 of the first housing 11.

According to an embodiment, the second support 52 may be disposed or coupled to the first support 51. At least a portion of the second support 52 may be positioned between the first support surface 51A of the first support 51 and the second cover 112 of the first housing 11.

According to an embodiment, the second support 52 may be disposed or coupled to the first support 51 through screw fastening, snap-fit, various other methods, or a combination of at least two of these methods.

According to an embodiment, the first support 51 is an internal structure positioned within the inner space of the first housing 11, and may also be referred to by other terms such as "first support body," "first support member," or "first support structure." The second support 52 is an internal structure positioned within the inner space of the first housing 11, and may also be referred to by other terms such as "second support body," "second support member," or "second support structure."

According to an embodiment, the combination of the first cover 111, the second cover 112, the first support 51, and the second support 52 may provide a durable frame (or frame structure or framework). Components such as the first printed circuit board 61, the second printed circuit board 62, the first connection terminal 13, the second connection terminal 14, the first light-emitting module 71, the second light-emitting module 72, the antenna structure 73, the first magnetic element 81, the second magnetic element 82, the third magnetic element 83, the fourth magnetic element 84, and the fifth magnetic element 85 may be arranged on or supported by the frame.

According to various embodiments, the first support 51 may be interpreted as a portion of the first housing 11.

According to various embodiments, the second support 52 may be interpreted as a portion of the first housing 11.

According to an embodiment, the first support 51 or the second support 52 may include non-conductive material and/or conductive material.

According to an embodiment, the first printed circuit board 61 may be disposed or coupled to the first support 51 through screw fastening, snap-fit, bonding, various other methods, or a combination of at least two of these methods. The first printed circuit board 61 may be disposed or coupled to the first support surface 51A of the first support 51. The first printed circuit board 61 may be at least partially positioned between the first support 51 and the first cover 111 of the first housing 11. A portion of the first printed circuit board 61 may be positioned between the hinge module 4 and the first support 51.

According to an embodiment, the second printed circuit board 62 may be disposed or coupled to the first support 51 through screw fastening, snap-fit, bonding, various other methods, or a combination of at least two of these methods. The second printed circuit board 62 may be disposed or coupled to the first support surface 51A of the first support 51. The second printed circuit board 62 may be at least partially positioned between the first support 51 and the first cover 111 of the first housing 11.

According to an embodiment, the second printed circuit board 62 may be at least partially positioned between the first support 51 and the second support 52.

According to an embodiment, the first printed circuit board 61 and the second printed circuit board 62 may be electrically connected to each other. When viewed from above the second cover 112 of the first housing 11 (e.g., in the -z-axis direction), the first printed circuit board 61 and the second printed circuit board 62 may be electrically connected via an overlapping portion (hereinafter referred to as an "overlap section"). The overlap section may include a first connector (not separately illustrated) disposed on the first printed circuit board 61 and a second connector 621 disposed on the second printed circuit board 62 and electrically connected to the first connector.

According to an embodiment, the first printed circuit board 61 may be implemented as a substantially rigid printed circuit board.

According to various embodiments, the first printed circuit board 61 may be implemented as a flexible printed circuit board (FPCB) that includes at least a partially flexible portion.

According to an embodiment, the second printed circuit board 62 may be implemented as a flexible printed circuit board that includes at least a partially flexible portion.

According to various embodiments, the second printed circuit board 62 may be implemented as a substantially rigid printed circuit board.

According to an embodiment, the first connection terminal 13 and the second connection terminal 14 may be disposed or coupled to the second support 52.

According to an embodiment, the first connection terminal 13 may include one or more first pogo pins (e.g., a pair of first pogo pins) disposed or coupled to the second support 52. The one or more first pogo pins may be positioned in a first opening (not separately illustrated) provided in the second cover 112 to correspond to the first recess 201. The second connection terminal 14 may include one or more second pogo pins (e.g., a pair of second pogo pins) disposed or coupled to the second support 52. The one or more second pogo pins may be positioned in a second opening (not separately illustrated) provided in the second cover 112 to correspond to the second recess 202.

According to an embodiment, the first connection terminal 13 and the second connection terminal 14 may be electrically connected to the first printed circuit board 61 via the second printed circuit board 62.

According to an embodiment, the first connection terminal 13 may be electrically connected to a first terminal portion 622 included in the second printed circuit board 62. The second connection terminal 14 may be electrically connected to a second terminal portion 623 included in the second printed circuit board 62.

According to an embodiment, the first connection terminal 13 or the first terminal portion 622 may include a first flexible conductive portion (not separately illustrated) that allows the first connection terminal 13 and the first terminal portion 622 to come into elastic and physical contact with each other. The second connection terminal 14 or the second terminal portion 623 may include a second flexible conductive portion (not separately illustrated) that allows the second connection terminal 14 and the second terminal portion 623 to come into elastic and physical contact with each other. The first flexible conductive portion or the second flexible conductive portion may include, for example, a conductive clip (e.g., a conductive structure with an elastic structure), a spring, a conductive poron, a conductive rubber, a conductive tape, or a conductive connector.

According to an embodiment, the first light-emitting module 71 and the second light-emitting module 72 may be disposed or coupled to the second support 52. The first light-emitting module 71 may be disposed or coupled to the second support 52 to correspond to the first light-transmitting area 16 provided in the second cover 112 of the first housing 11. The second light-emitting module 72 may be disposed or coupled to the second support 52 to correspond to the second light-transmitting area 17 provided in the first cover 111 of the first housing 11.

According to an embodiment, the first light-emitting module 71 and the second light-emitting module 72 may be electrically connected to the first printed circuit board 61 via the second printed circuit board 62.

According to an embodiment, the first light-emitting module 71 may be electrically connected to a third terminal portion 624 included in the second printed circuit board 62. The second light-emitting module terminal 72 may be electrically connected to a fourth terminal portion 625 included in the second printed circuit board 62.

According to an embodiment, the first light-emitting module 71 or the third terminal portion 624 may include a third flexible conductive portion (not separately illustrated) that allows the first light-emitting module 71 and the third terminal portion 624 to come into elastic and physical contact with each other. The second light-emitting module 72 or the fourth terminal portion 625 may include a fourth flexible conductive portion (not separately illustrated) that allows the second light-emitting module 72 and the fourth terminal portion 625 to come into elastic and physical contact with each other. The third flexible conductive portion or the fourth flexible conductive portion may include, for example, a conductive clip (e.g., a conductive structure with an elastic structure), a spring, a conductive poron, a conductive rubber, a conductive tape, or a conductive connector.

According to an embodiment, the antenna structure 73 may be disposed on the first support 51. In the folded state of the foldable electronic device 1, the antenna structure 73 may be disposed or coupled to the second support surface (or second support area) of the first support 51, which faces the rear surface of the foldable electronic device 1.

According to an embodiment, the antenna structure 73 may be implemented in the form of a film, such as a flexible printed circuit board.

According to an embodiment, the antenna structure 73 may include at least one conductive pattern (not separately illustrated) utilized as a loop-shaped radiator. For example, the at least one conductive pattern included in the antenna structure 73 may include a planar spiral conductive pattern (e.g., a planar coil or pattern coil).

According to an embodiment, the at least one conductive pattern included in the antenna structure 73 may be electrically connected to a power transmission/reception circuit disposed on the first printed circuit board 61. The power transmission/reception circuit may wirelessly receive power from an external electronic device (not separately illustrated) or wirelessly transmit power to an external electronic device using the at least one conductive pattern. The power transmission/reception circuit may include a power management module and may include, for example, a power management integrated circuit (PMIC) or a charger integrated circuit (IC).

According to an embodiment, the power management module may charge a first battery (not separately illustrated) included in the first wireless earphone 31 (see FIG. 3), which is electrically connected to the first connection terminal 13, using power received from an external electronic device (not separately illustrated) via the antenna structure 73 or the third connection terminal 15. The power management module may charge a second battery (not separately illustrated) included in the second wireless earphone 32 (see FIG. 3), which is electrically connected to the second connection terminal 14, using power received from an external electronic device (not separately illustrated) via the antenna structure 73 or the third connection terminal 15.

According to an embodiment, the third connection terminal 15 may be disposed on the first printed circuit board 61. The third connection terminal 15 may be positioned to correspond to a connector hole 151 provided in the second cover 112 of the first housing 11.

According to an embodiment, the first magnetic element 81, the second magnetic element 82, the third magnetic element 83, and the fourth magnetic element 84 may be disposed or coupled to the second support 52.

According to an embodiment, the first magnetic element 81 and the second magnetic element 82 may be disposed or coupled to the second support 52 to correspond to the first recess 201 of the first housing 11. The first wireless earphone 31 (see FIG. 3) may include a first magnetic element counterpart portion (not separately illustrated) capable of generating an attractive force with the first magnetic element 81 in response to the magnetic force of the first magnetic element 81. The first wireless earphone 31 (see FIG. 3) may include a second magnetic element counterpart portion (not separately illustrated) capable of generating an attractive force with the second magnetic element 82 in response to the magnetic force of the second magnetic element 82. When the first wireless earphone 31 is placed in the first recess 201, the attractive force between the first magnetic element 81 and the first magnetic element counterpart portion and the attractive force between the second magnetic element 82 and the second magnetic element counterpart portion may be provided.

According to an embodiment, the third magnetic element 83 and the fourth magnetic element 84 may be disposed or coupled to the second support 52 to correspond to the second recess 202 of the first housing 11. The second wireless earphone 32 (see FIG. 3) may include a third magnetic element counterpart portion (not separately illustrated) capable of generating an attractive force with the third magnetic element 83 in response to the magnetic force of the third magnetic element 83. The second wireless earphone 32 (see FIG. 3) may include a fourth magnetic element counterpart portion (not separately illustrated) capable of generating an attractive force with the fourth magnetic element 84 in response to the magnetic force of the fourth magnetic element 84. When the second wireless earphone 32 is placed in the second recess 202, the attractive force between the third magnetic element 83 and the third magnetic element counterpart portion and the attractive force between the fourth magnetic element 84 and the fourth magnetic element counterpart portion may be provided.

According to an embodiment, the first magnetic element 81, the second magnetic element 82, the third magnetic element 83, or the fourth magnetic element 84 may include a magnet including a magnetic dipole with an N-pole and an S-pole. The first magnetic element counterpart portion or the second magnetic element counterpart portion included in the first wireless earphone 31 (see FIG. 3) may include a magnet including a magnetic dipole with an N-pole and an S-pole, or a material capable of being magnetized in response to a magnet. The third magnetic element counterpart portion or the fourth magnetic element counterpart portion included in the second wireless earphone 32 (see FIG. 3) may include a magnet including a magnetic dipole with an N-pole and an S-pole, or a material capable of being magnetized in response to a magnet.

According to an embodiment, the fifth magnetic element 85 may be accommodated in the first housing 11, and the sixth magnetic element 86 may be accommodated in the second housing 12. In the folded state of the foldable electronic device 1, an attractive force may be provided between the fifth magnetic element 85 and the sixth magnetic element 86. The attractive force between the fifth magnetic element 85 and the sixth magnetic element 86 may reduce or prevent separation between the first housing 11 and the second housing 12.

According to an embodiment, the fifth support 85 may be disposed or coupled to the second support 52.

According to an embodiment, the fifth magnetic element 85 and the sixth magnetic element 86 may be magnets including magnetic dipoles with N-poles and S-poles.

According to various embodiments, one of the fifth magnetic element 85 and the sixth magnetic element 86 may be a magnet including a magnetic dipole with an N-pole and an S-pole, and the remaining one may include a material capable of being magnetized in response to a magnet.

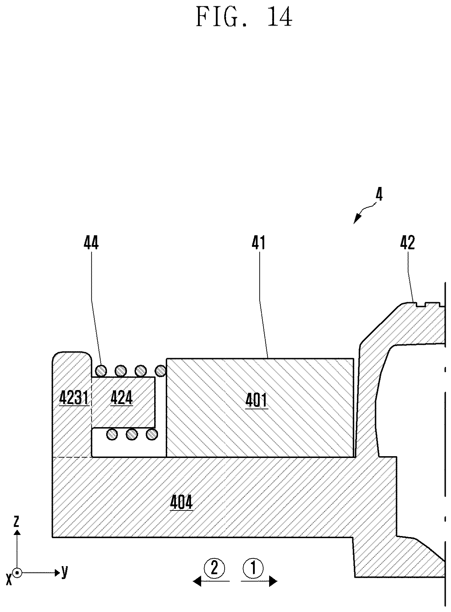

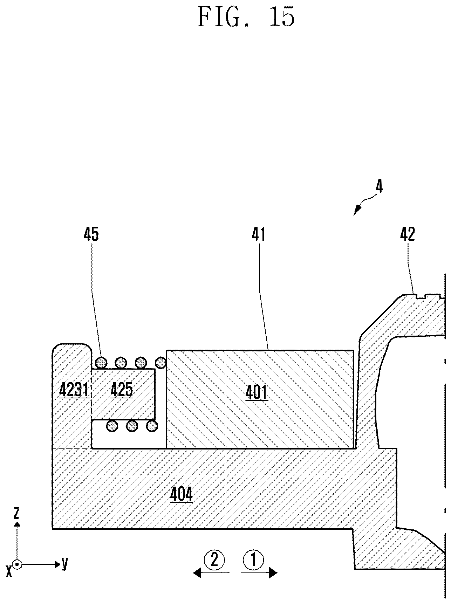

FIG. 14 is a cross-sectional view of the hinge module 4, taken along line F-F' in FIG. 11, according to an embodiment of the disclosure. FIG. 15 is a cross-sectional view of the hinge module 4, taken along line G-G' in FIG. 11, according to an embodiment of the disclosure.

Referring to FIGS. 14 and 15, the hinge module 4 may include a first bracket 41, a second bracket 42, a first elastic element 44, and/or a second elastic element 45.

According to an embodiment, the first portion 401 of the first bracket 41 may include a first elastic element support 411 (see FIG. 11) and a second elastic element support 412 (see FIG. 11). The second bracket 42 may include a first support wall 4231. The first elastic element 44 may be disposed between the first elastic element support 411 and the first support wall 4231. The second elastic element 45 may be disposed between the second elastic element support 412 and the first support wall 4231.

According to an embodiment, the second bracket 42 may include a first protrusion 424 extending from the first support wall 4231. The first protrusion 424 may be inserted into the central space of the first elastic element 44 (e.g., a first coil compression spring). The second bracket 42 may include a second protrusion 425 extending from the first support wall 4231. The second protrusion 425 may be inserted into the central space of the second elastic element 45 (e.g., a second coil compression spring).

According to an embodiment, when the foldable electronic device 1 is in the first folded state, the first protrusion 424 may be spaced apart from the first elastic element support 411 in a second direction ② (see FIG. 14). When the foldable electronic device 1 is in the first folded state, the second protrusion 425 may be spaced apart from the second elastic element support 412 in the second direction ② (see FIG. 14). When an external force is applied to switch the foldable electronic device 1 from the first folded state to the second folded state, the distance between the first protrusion 424 and the first elastic element support 411 may decrease, or the first protrusion 424 may come into contact with the first elastic element support 411, and the first elastic element 44 may be compressed compared to the first folded state (not separately illustrated). When an external force is applied to switch the foldable electronic device 1 from the first folded state to the second folded state, the distance between the second protrusion 425 and the second elastic element support 412 may decrease, or the second protrusion 425 may come into contact with the second elastic element support 412, and the second elastic element 45 may be compressed compared to the first folded state (not separately illustrated).

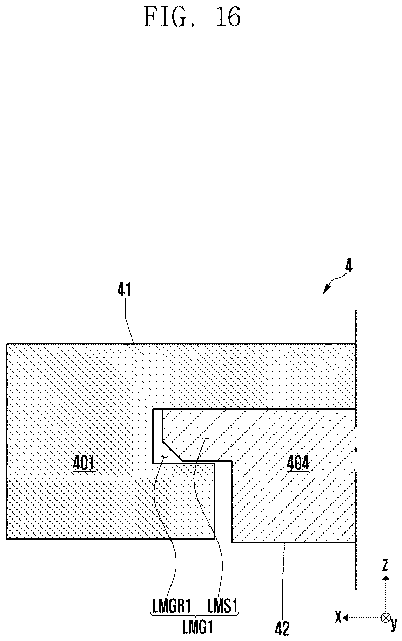

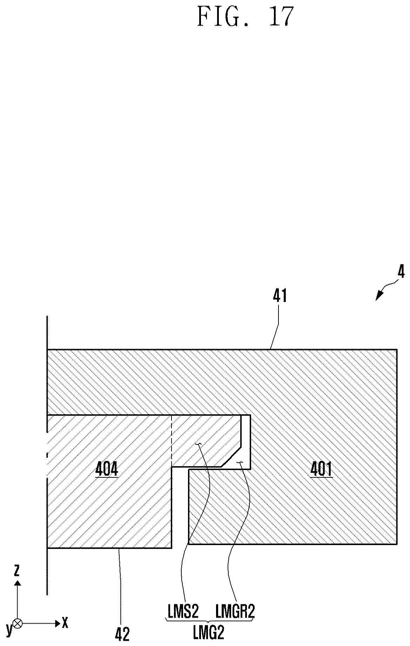

FIG. 16 is a cross-sectional view of the hinge module 4, taken along line H-H' of FIG. 11, according to an embodiment of the disclosure. FIG. 17 is a cross-sectional view of the hinge module 4, taken along line I-I' of FIG. 11, according to an embodiment of the disclosure.

Referring to FIGS. 16 and 17, the hinge module 4 may include a first bracket 41 and a second bracket 42.

According to an embodiment, the hinge module 4 may include a first linear motion guide LMG1 and a second linear motion guide LMG2 to allow the first bracket 41 and the second bracket 42 to slide relative to each other in a linear direction (e.g., mutual linear motion).

According to an embodiment, the first linear motion guide LMG1 and the second linear motion guide LMG2 may connect the first portion 401 of the first bracket 41 and the fourth portion 404 of the second bracket 42 to mutually slide in a linear direction.

According to an embodiment, the first linear motion guide LMG1 may include a first linear motion guide rail LMGR1 included in the first portion 401 of the first bracket 41 and a first linear motion slider LMS1 included in the fourth portion 404 of the second bracket 42. The first linear motion slider LMS1 may be inserted into the first linear motion guide rail LMGR1. Depending on the sliding position of the second bracket 42 relative to the first bracket 41, the relative position between the first linear motion slider LMS1 and the first linear motion guide rail LMGR1 may vary.

According to an embodiment, the second linear motion guide LMG2 may include a second linear motion guide rail LMGR2 included in the first portion 401 of the first bracket 41 and a second linear motion slider LMS2 included in the fourth portion 404 of the second bracket 42. The second linear motion slider LMS2 may be inserted into the second linear motion guide rail LMGR2. Depending on the sliding position of the second bracket 42 relative to the first bracket 41, the relative position between the second linear motion slider LMS2 and the second linear motion guide rail LMGR2 may vary.

According to an embodiment, the first linear motion guide LMG1, provided by the combination of the first linear motion guide rail LMGR1 and the first linear motion slider LMS1 (e.g., a first sliding pair), and the second linear motion guide LMG2, provided by the combination of the second linear motion guide rail LMGR2 and the second linear motion slider LMS2 (e.g., a second sliding pair), may stably connect the first bracket 41 and the second bracket 42 to allow mutual sliding in a linear direction.

According to an embodiment, the first linear motion guide LMG1 and the second linear motion guide LMG2 may be provided symmetrically with respect to the centerline B (see FIG. 11) of the hinge module 4. The first linear motion guide LMG1 and the second linear motion guide LMG2, which are provided symmetrically with respect to the centerline B (see FIG. 11) of the hinge module 4, may contribute to stable and balanced mutual sliding between the first bracket 41 and the second bracket 42. Based on the first elastic element 44 (see FIG. 4) and the second elastic element 45 (see FIG. 4), which provide elasticity between the first bracket 41 and the second bracket 42, the first linear motion guide LMG1 and the second linear motion guide LMG2 may enable stable and balanced linear motion (or translational motion) of the second housing 12 connected to the second bracket 42 relative to the first housing 11 connected to the first bracket 41.

According to an embodiment, the first linear motion guide LMG1 and the second linear motion guide LMG2 may enable the linear motion of the second bracket 42 fixed to the second housing 12 relative to the first bracket 41 fixed to the first housing 11, while substantially restricting rotational motion of the second bracket 42 relative to the first bracket 41.

According to various embodiments, the illustrated embodiment may be modified such that the first linear motion guide rail LMGR1 and the second linear motion guide rail LMGR2 are provided by the second bracket 42, and the first linear motion slider LMS1 and the second linear motion slider LMS2 are provided by the first bracket 41 (not separately illustrated).

According to various embodiments, a lubricating material (e.g., grease) (not separately illustrated) may be disposed between the first linear motion guide rail LMGR1 and the first linear motion slider LMS1, and between the second linear motion guide rail LMGR2 and the second linear motion slider LMS2.

According to various embodiments, the friction surfaces between the first linear motion guide rail LMGR1 and the first linear motion slider LMS1 and between the second linear motion guide rail LMGR2 and the second linear motion slider LMS2 may be coated or otherwise treated with a lubricating material (e.g., Teflon) (not separately illustrated).

According to various embodiments, the first linear motion slider LMS1 may include a first rotating body (not separately illustrated), such as a roller, and the second linear motion slider LMS2 may include a second rotating body (not separately illustrated), such as a roller.

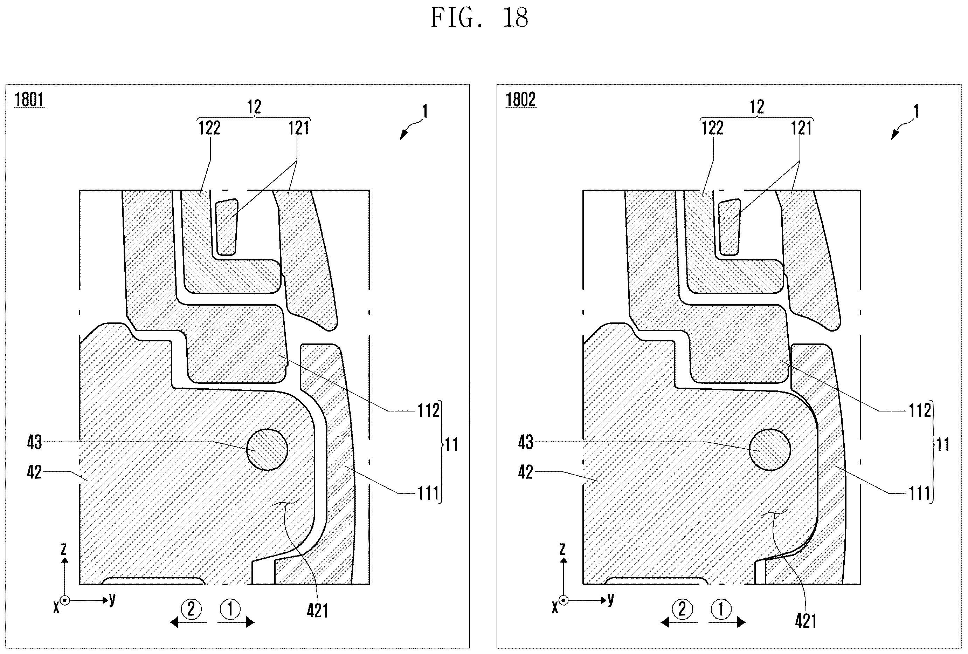

FIG. 18 illustrates a cross-sectional view 1801 of the foldable electronic device 1 in a first folded state, taken along line C-C' of FIG. 7, and a cross-sectional view 1802 of the foldable electronic device 1 in a second folded state, taken along line C-C' of FIG. 7, according to an embodiment of the disclosure.

Referring to FIG. 18, the foldable electronic device 1 may include the first housing 11, the second housing 12, a second bracket 42, and/or the shaft 43.

According to an embodiment, the first cover 111 of the first housing 11 may be connected to the first bracket 41 (see FIG. 4) of the hinge module 4. The fourth cover 122 of the second housing 12 may be connected to the second bracket 42 of the hinge module 4 via the shaft 43.

According to an embodiment, the second bracket 42 of the hinge module 4 may include the first shaft support 421 and the second shaft support 422 (see FIG. 7). The first shaft support 421 and the second shaft support 422 (see FIG. 7) may be connected to the fourth cover 122 of the second housing 12 via the shaft 43.

Although a cross-sectional view of the foldable electronic device 1 in the first folded state taken along line D-D' of FIG. 7 is not separately illustrated, it may be provided in a manner substantially identical or similar to the cross-sectional view 1801 illustrated to correspond to the second shaft support 422 of the second bracket 42 (see FIG. 7). Although a cross-sectional view of the foldable electronic device 1 in the second folded state taken along line D-D' of FIG. 7 is not separately illustrated, it may be provided in a manner substantially identical or similar to the cross-sectional view 1802 illustrated to correspond to the second shaft support 422 of the second bracket 42 (see FIG. 7).

According to an embodiment, when an external force is applied to linearly move the second housing 12 in the first direction ① relative to the first housing 11, the second bracket 42 connected to the second housing 12 may linearly move in the first direction ① relative to the first bracket 41 (see FIG. 7) connected to the first housing 11, and the foldable electronic device 1 may be switched from the first folded state (see the cross-sectional view 1801) to the second folded state (see the cross-sectional view 1802).

According to an embodiment, when the second bracket 42 is linearly moved in the second direction ②, opposite to the first direction ①, relative to the first bracket 41 (see FIG. 7) due to the elasticity of the first elastic element 44 (see FIG. 7) and the elasticity of the second elastic element 45 (see FIG. 7), the second housing 12 connected to the second bracket 42 may linearly move in the second direction ② relative to the first housing 11 connected to the first bracket 41, and the foldable electronic device 1 may be switched from the second folded state (see the cross-sectional view 1802) to the first folded state (see the cross-sectional view 1801).

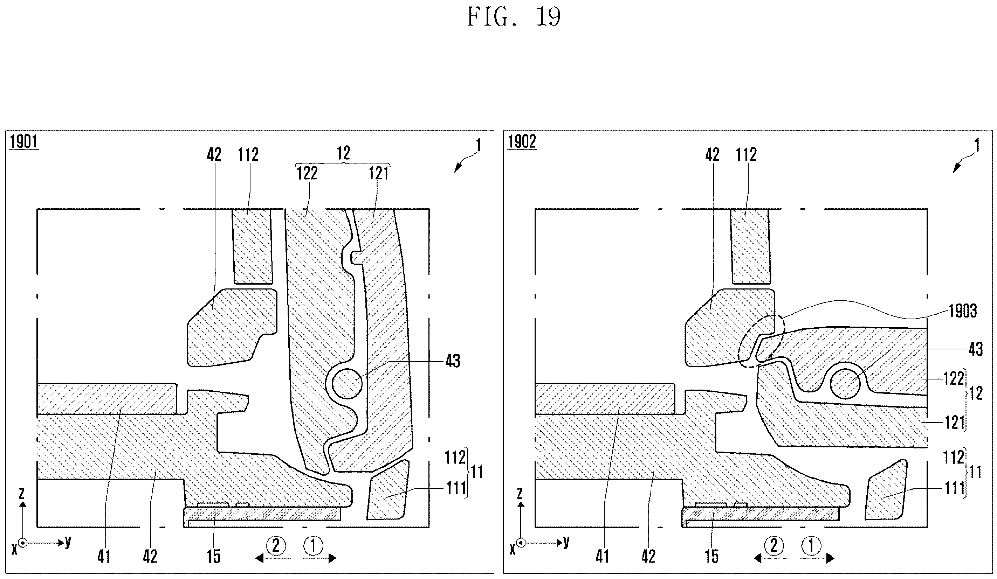

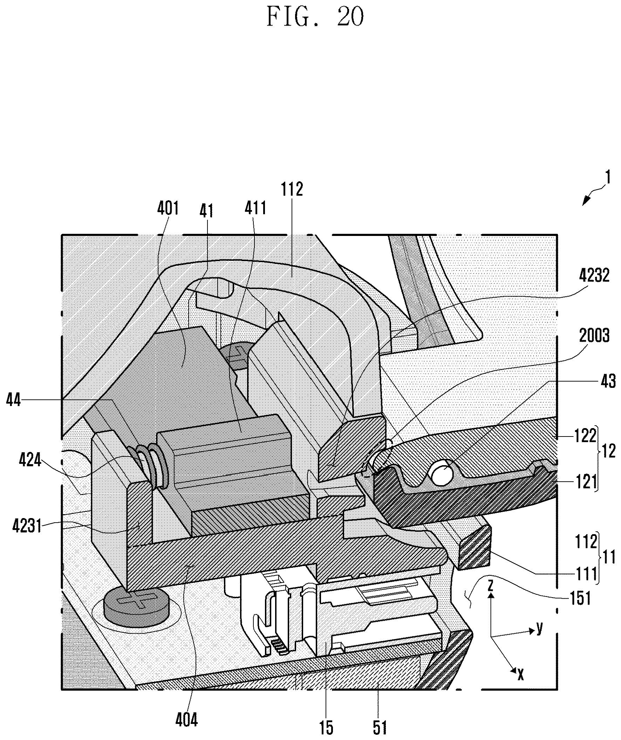

FIG. 19 illustrates a cross-sectional view 1901 of the foldable electronic device 1 in the second folded state, taken along line E-E' of FIG. 7, and a cross-sectional view 1902 of the foldable electronic device 1 in the unfolded state, taken along line E-E' of FIG. 7, according to an embodiment of the disclosure. FIG. 20 illustrates a cross-sectional perspective view of a portion of the foldable electronic device 1 in the unfolded state, taken along line E-E' in FIG. 7, according to an embodiment of the disclosure.

Referring to FIGS. 19 and 20, the foldable electronic device 1 may include the first housing 11, the second housing 12, the first support 51, the first bracket 41, the second bracket 42, the shaft 43, the first elastic element 44, the first screw 46, the first printed circuit board 61, and/or the third connection terminal 15.

According to an embodiment, when an external force is applied to rotate the second housing 12 relative to the first housing 11, the second housing 12 may rotate around the shaft 43, and the foldable electronic device 1 may be switched from the second folded state to the unfolded state. Due to interference (see "1903" and "2003") between the second bracket 42 and the second housing 12, the maximum opening angle of the second housing 12 relative to the first housing 11 may be restricted.

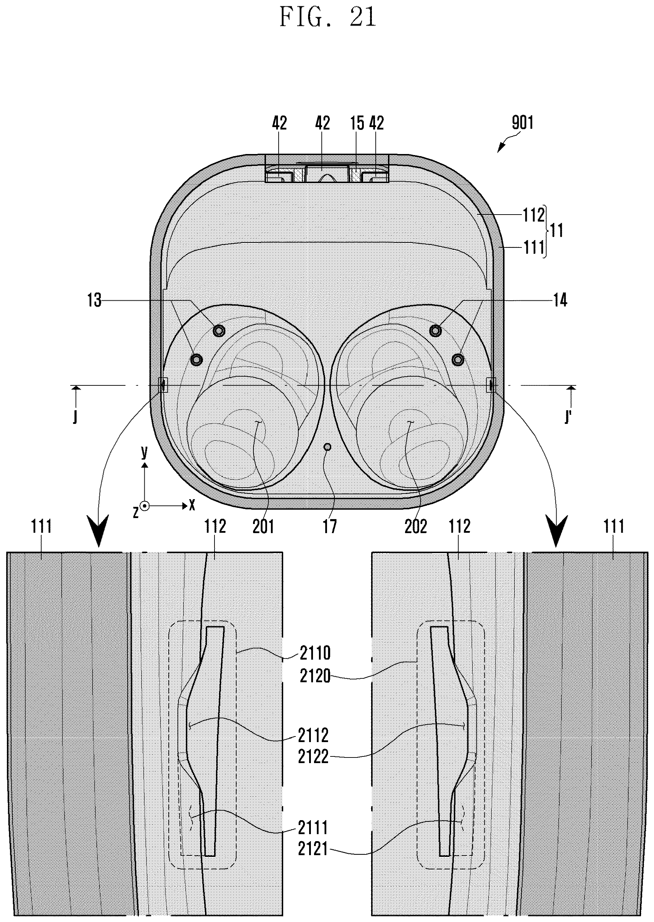

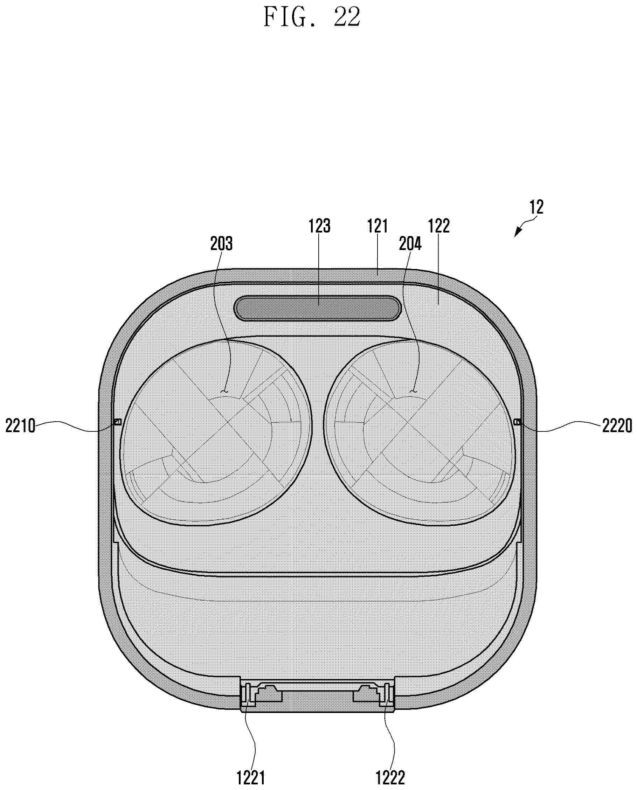

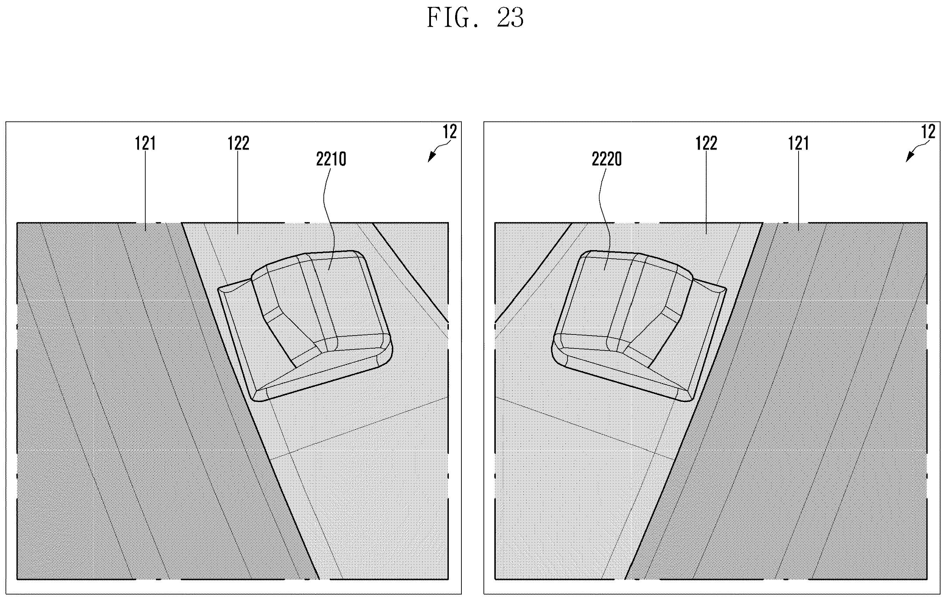

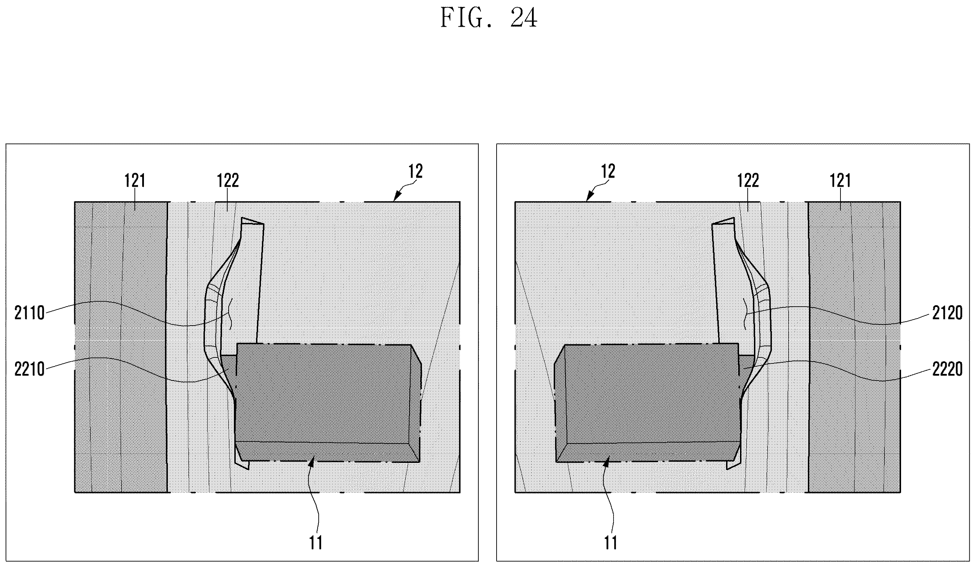

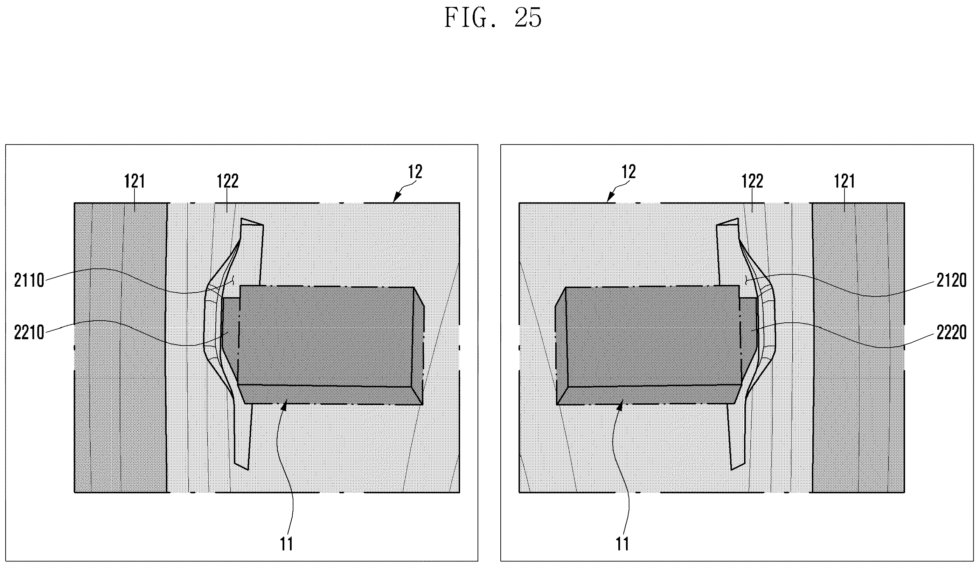

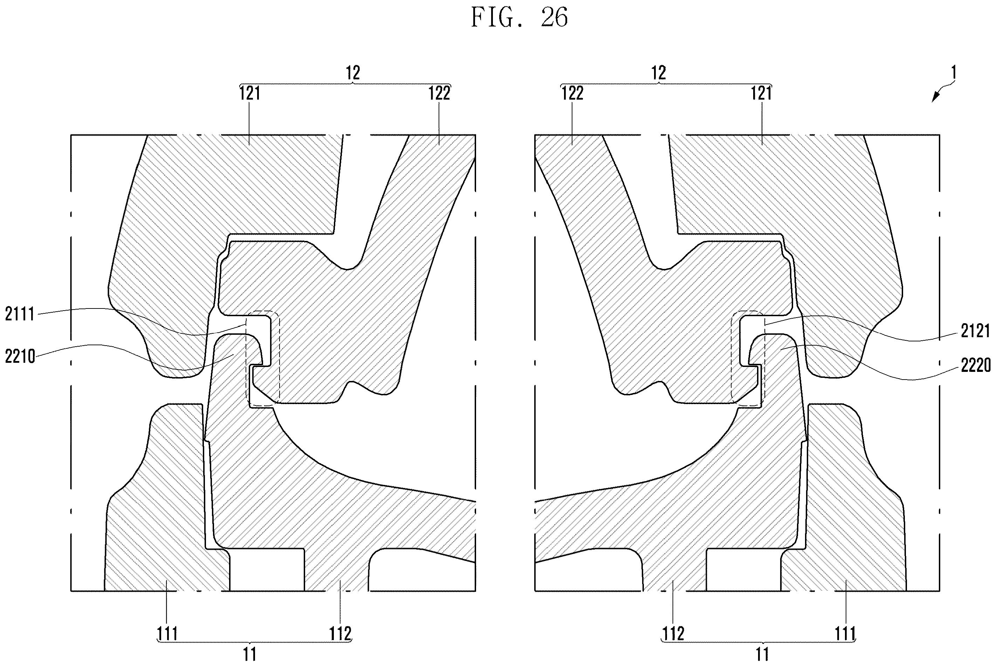

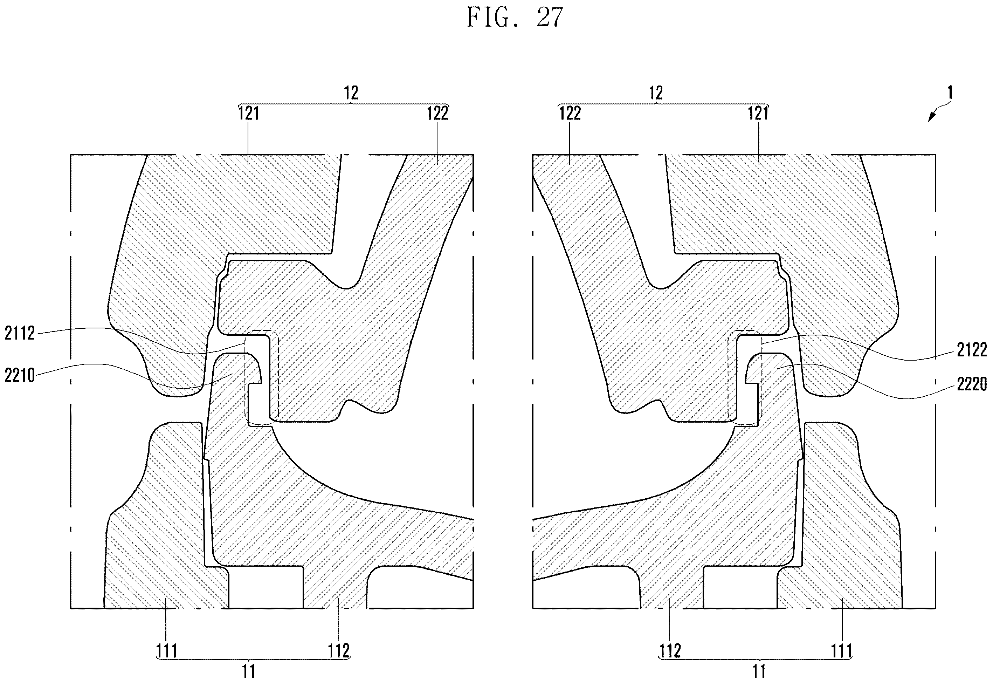

FIG. 21 is a view illustrating a combination of multiple components (e.g., the fifth combination 901 of FIG. 9) included in the foldable electronic device 1, according to an embodiment of the disclosure. FIG. 22 is a view illustrating the second housing 12 according to an embodiment of the disclosure. FIG. 23 is a perspective view of the second housing 12 according to an embodiment of the disclosure. FIG. 24 is a perspective view illustrating the second housing 12, the first hook 2210, and the second hook 2220 in the first folded state of the foldable electronic device 1 according to an embodiment of the disclosure. FIG. 25 is a perspective view illustrating the second housing 12, the first hook 2210, and the second hook 2220 in the second folded state of the foldable electronic device 1 according to an embodiment of the disclosure. FIG. 26 is a cross-sectional view of the foldable electronic device 1 in the first folded state, taken along line J-J' of FIG. 21, according to an embodiment of the disclosure. FIG. 27 is a cross-sectional view of the foldable electronic device 1 in the second folded state, taken along line J-J' of FIG. 21, according to an embodiment of the disclosure.

Among the components illustrated in FIGS. 21, 22, 23, 24, 25, 26, and 27, the description is omitted for at least one component that has already described with reference to FIGS. 4, 5, 6, 7, 8, 9, 10, 11, 12, and 13.

Referring to FIGS. 21, 22, 23, 24, 25, 26, and 27, the second cover 112 of the first housing 11 may include a first fastening portion 2110 and a second fastening portion 2120. The fourth cover 122 of the second housing 12 may include a first hook 2210 corresponding to the first fastening portion 2110 and a second hook 2220 corresponding to the second fastening portion 2120.

According to an embodiment, the first fastening portion 2110 may be provided in the form of a recess, and the first hook 2210 may be inserted into the first fastening portion 2110 in the folded state of the foldable electronic device 1. The first fastening portion 2110 may include a first interference portion (or first interference area, first engagement portion, or first engagement area) 2111 and a first non-interference portion (or first non-interference area, first non-engagement portion, or first non-engagement area) 2112.

According to an embodiment, in the first folded state of the foldable electronic device 1, due to the relative position between the first housing 11 and the second housing 12 corresponding to the first folded state, the first hook 2210 may be positioned to correspond to the first interference portion 2111 of the first fastening portion 2110, and interference between the first hook 2210 and the first fastening portion 2110 may be provided. In the second folded state of the foldable electronic device 1, due to the relative position between the first housing 11 and the second housing 12 corresponding to the second folded state, the first hook 2210 may be positioned to correspond to the first non-interference portion 2112 of the first fastening portion 2110, and interference between the first hook 2210 and the first fastening portion 2110 may be released.

According to an embodiment, the second fastening portion 2120 may be provided in the form of a recess, and the second hook 2220 may be inserted into the second fastening portion 2120 in the folded state of the foldable electronic device 1. The second fastening portion 2120 may include a second interference portion (or second interference area, second engagement portion, or second engagement area) 2121 and a second non-interference portion (or second non-interference area, second non-engagement portion, or second non-engagement area) 2122.

According to an embodiment, in the first folded state of the foldable electronic device 1, due to the relative position between the first housing 11 and the second housing 12 corresponding to the first folded state, the second hook 2220 may be positioned to correspond to the second interference portion 2121 of the second fastening portion 2120, and interference between the second hook 2220 and the second fastening portion 2120 may be provided. In the second folded state of the foldable electronic device 1, due to the relative position between the first housing 11 and the second housing 12 corresponding to the second folded state, the second hook 2220 may be positioned to correspond to the second non-interference portion 2122 of the second fastening portion 2120, and interference between the second hook 2220 and the second fastening portion 2120 may be released.

According to an embodiment, the first fastening portion 2110 and the second fastening portion 2120 may be provided substantially symmetrically with respect to the centerline B (see FIG. 7) of the hinge module 4.

According to an embodiment, the interference between the first hook 2210 and the first fastening portion 2110 and the interference between the second hook 2220 and the second fastening portion 2120 may reduce or prevent the foldable electronic device 1 from being switched from the folded state to the unfolded state due to external impacts such as dropping.

According to an embodiment, the elasticity of the first elastic element 44 (see FIG. 4) and the elasticity of the second elastic element 45 (see FIG. 4) may provide a retaining force that maintains the first housing 11 and the second housing 12 in a relative positional relationship corresponding to the first folded state. The elasticity of the first elastic element 44 and the elasticity of the second elastic element 45 may provide a force that maintains the interference between the first hook 2210 and the first fastening portion 2110 and the interference between the second hook 2220 and the second fastening portion 2120, against external impacts such as dropping.

According to an embodiment, the second folded state, in which the interference between the first hook 2210 and the first fastening portion 2110 is released, and the interference between the second hook 2220 and the second fastening portion 2120 is released, may be interpreted as an intermediate state between the first folded state and the unfolded state that allows the foldable electronic device 1 to switch to the unfolded state.

In various embodiments, the illustrated embodiment may be modified such that the first fastening portion 2110 and the second fastening portion 2120 are included in the fourth cover 122 of the second housing 12, and the first hook 2210 and the second hook 2220 are included in the second cover 112 of the first housing 11.

According to various embodiments, when the foldable electronic device 1 is implemented to include the first fastening portion 2110, the second fastening portion 2120, the first hook 2210, and the second hook 2220, the fifth magnetic element 85 and the sixth magnetic element 86 of the embodiment in FIG. 4 may be omitted.

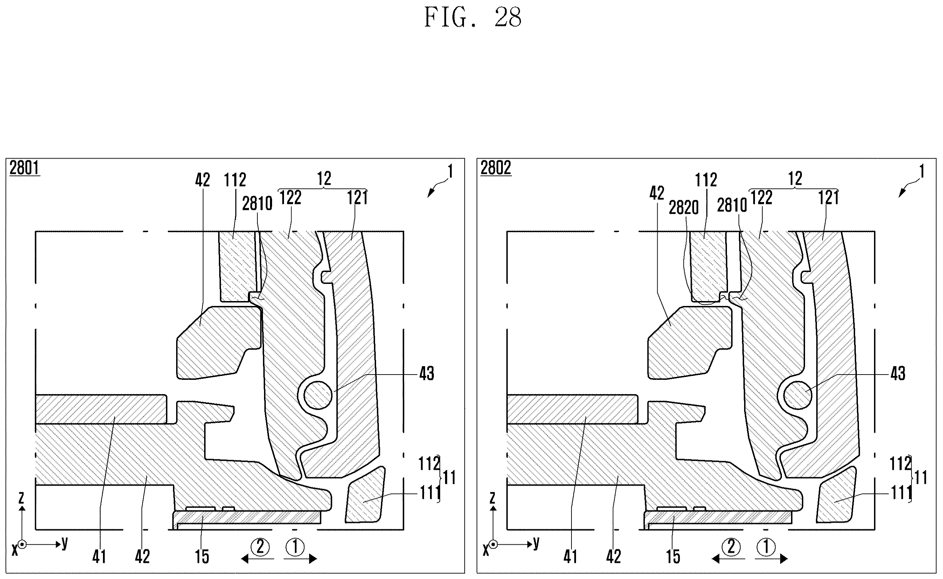

FIG. 28 illustrates a cross-sectional view 2801 of the foldable electronic device 1 in the first folded state, taken along line E-E' of FIG. 7, and a cross-sectional view 2802 of the foldable electronic device 1 in a second unfolded state, taken along line E-E' of FIG. 7, according to an embodiment of the disclosure.

Referring to FIG. 28, the foldable electronic device 1 may include the first housing 11, the second housing 12, the first bracket 41, the second bracket 42, the shaft 43, and/or the third connection terminal 15.

According to an embodiment, the fourth cover 122 of the second housing 12 may include a third hook 2810. The second cover 112 of the first housing 11 may include a hook engagement portion 2820 corresponding to the third hook 2810.

According to an embodiment, in the first folded state (see cross-sectional view "2801"), due to the relative position between the first housing 11 and the second housing 12 corresponding to the first folded state of the foldable electronic device 1, the third hook 2810 may be positioned to correspond to the hook engagement portion 2820, and interference may be provided between the third hook 2810 and the hook engaging portion 2820.

According to an embodiment, the interference between the third hook 2810 and the hook engagement portion 2820 may reduce or prevent the foldable electronic device 1 from being switched from the folded state to the unfolded state due to external impacts such as dropping.

According to an embodiment, in the second folded state of the foldable electronic device 1, due to the relative position between the first housing 11 and the second housing 12 corresponding to the second folded state, the third hook 2810 may be disengaged from the hook engagement portion 2820, and the interference between the third hook 2810 and the hook engagement portion 2820 may be released.

According to an embodiment, the second folded state, in which the interference between the third hook 2810 and the hook engagement portion 2820 is released, may be interpreted as an intermediate state between the first folded state and the unfolded state that allows the foldable electronic device 1 to be switched to the unfolded state.

According to various embodiments, the foldable electronic device 1 may be implemented to include at least a portion of a combinations of the embodiment illustrated in FIGS. 21 to 27 (e.g., the first fastening portion 2110, the second fastening portion 2120, the first hook 2210, and the second hook 2220) and the embodiment of FIG. 28 (e.g., the third hook 2810 and the hook engagement portion 2820).

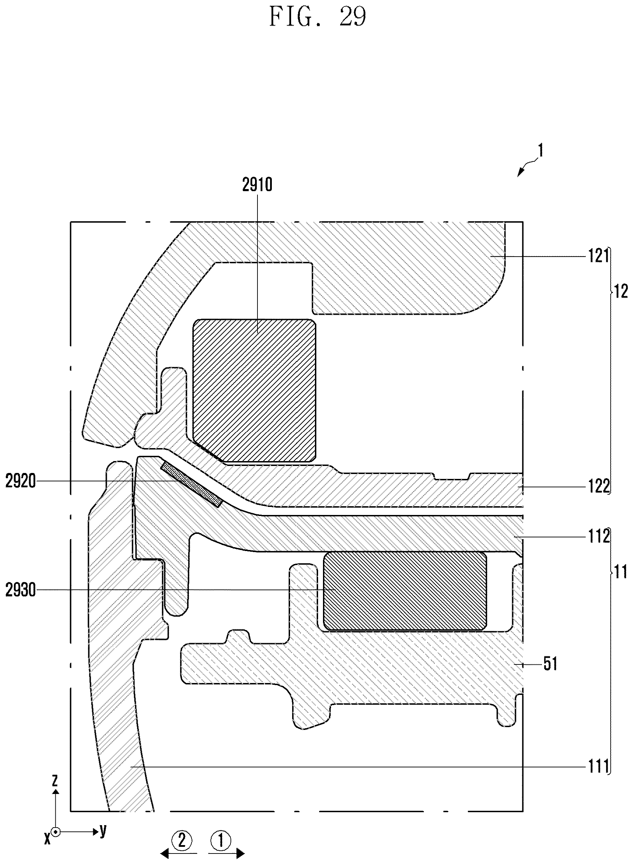

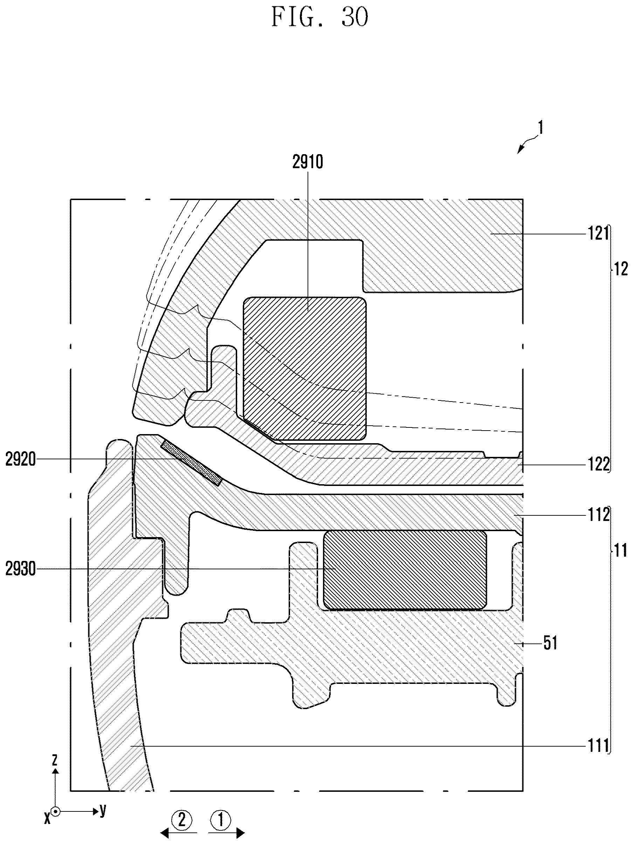

FIG. 29 is a cross-sectional view of the foldable electronic device 1 in the first folded state, taken along line E-E' of FIG. 7, according to an embodiment of the disclosure. FIG. 30 is a cross-sectional view of the foldable electronic device 1 n the second folded state, taken along line E-E' of FIG. 7, according to an embodiment of the disclosure.

Referring to FIGS. 29 and 30, the foldable electronic device 1 may include a first housing 11, a second housing 12, a first support 51, a seventh magnetic element 2910, an eighth magnetic element 2920, and/or a ninth magnetic element 2930.

The embodiment of FIGS. 29 and 30 may be that obtained by modifying the foldable electronic device 1 to include a seventh magnetic element 2910, an eighth magnetic element 2920, and a ninth magnetic element 2930 in place of the fifth magnetic element 85 and the sixth magnetic element 86 in the embodiment of FIG. 4.

Among the components illustrated in FIGS. 29 and 30, descriptions are omitted for some components that have been described with reference to FIGS. 4, 5, 6, 7, 8, 9, 10, 11, 12, and 13.

According to an embodiment, the seventh magnetic element 2910 may be disposed between the third cover 121 and the fourth cover 122 of the second housing 12.

In various embodiments, the seventh magnetic element 2910 may be disposed or coupled to the fourth cover 122.

In various embodiments, the seventh magnetic element 2910 may be at least partially disposed inside the fourth cover 122 (not separately illustrated).

According to an embodiment, the seventh magnetic element 2910 may be a magnet including a magnetic dipole with an N-pole and an S-pole.

According to an embodiment, the eighth magnetic element 2920 may be disposed on the second cover 112 of the first housing 11.

In various embodiments, the eighth magnetic element 2920 may be at least partially disposed inside the second cover 112 of the first housing 11 (not separately illustrated).

According to an embodiment, the eighth magnetic element 2920 may include a material capable of being magnetized in response to a magnet.

In various embodiments, the eighth magnetic element 2920 may be a magnet including a magnetic dipole with an N-pole and an S-pole.

According to an embodiment, the ninth magnetic element 2930 may be positioned between the first support 51 and the second cover 112 of the first housing 11. The ninth magnetic element 2930 may be disposed on or coupled to the second cover 112 or the first support 51.

In various embodiments, the ninth magnetic element 2930 may be at least partially disposed inside the second cover 112 of the first housing 11 (not separately illustrated).

According to an embodiment, the ninth magnetic element 2930 may be a magnet including a magnetic dipole with an N-pole and an S-pole.

According to an embodiment, when the foldable electronic device 1 is switched from the second folded state (see FIG. 30) to the first folded state (see FIG. 29), the relative position of the seventh magnetic element 2910 with respect to the eighth magnetic element 2920 and the ninth magnetic element 2930 may change such that the attractive force between the seventh magnetic element 2910 and the eighth magnetic element 2920 is provided to be relatively stronger than the repulsive force between the seventh magnetic element 2910 and the ninth magnetic element 2930 due to the relative position between the first housing 11 and the second housing 12 corresponding to the first folded state.

According to an embodiment, in the first folded state of the foldable electronic device 1 (see FIG. 29), the seventh magnetic element 2910 and the eighth magnetic element 2920 may be aligned due to the relative position between the first housing 11 and the second housing 12 corresponding to the first folded state. The attractive force between the aligned seventh and eighth magnetic elements 2910 and 2920 may reduce or prevent separation between the first housing 11 and the second housing 12 in the first folded state of the foldable electronic device 1. In the first folded state of the foldable electronic device 1, the repulsive force between the seventh magnetic element 2910 and the ninth magnetic element 2930 may be too small to substantially cause separation between the first housing 11 and the second housing 12, compared to the attractive force between the seventh magnetic element 2910 and the eighth magnetic element 2920.

According to an embodiment, when the foldable electronic device 1 is switched from the first folded state (see FIG. 29) to the second folded state (see FIG. 30), the relative position of the seventh magnetic element 2910 with respect to the eighth magnetic element 2920 and the ninth magnetic element 2930 may change such that the repulsive force between the seventh magnetic element 2910 and the ninth magnetic element 2930 is provided to be relatively stronger than the attractive force between the seventh magnetic element 2910 and the eighth magnetic element 2920 due to the relative position between the first housing 11 and the second housing 12 corresponding to the second folded state.

According to an embodiment, when the foldable electronic device 1 is switched from the first folded state (see FIG. 29) to the second folded state (see FIG. 30), the repulsive force between the seventh magnetic element 2910 and the ninth magnetic element 2930 may cause separation between the first housing 11 and the second housing 12. The second folded state may be defined or interpreted as including a state in which separation between the first housing 11 and the second housing 12 is caused by the repulsive force between the seventh magnetic element 2910 and the ninth magnetic element 2930. When the foldable electronic device 1 is switched from the first folded state to the second folded state, the attractive force between the seventh magnetic element 2910 and the eighth magnetic element 2920 may be too small to substantially suppress separation between the first housing 11 and the second housing 12, compared to the repulsive force between the seventh magnetic element 2910 and the ninth magnetic element 2930.

According to an embodiment, the second folded state, in which separation is provided between the first housing 11 and the second housing 12, may be interpreted as an intermediate state between the first folded state and the unfolded state, facilitating the switching of the foldable electronic device 1 to the unfolded state compared to the first folded state.

In various embodiments, the foldable electronic device 1 may be implemented to include at least a portion of a combination of the embodiment illustrated in FIGS. 21 to 27 (e.g., the first fastening portion 2110, the second fastening portion 2120, the first hook 2210, and the second hook 2220) and the embodiment of FIG. 29 (e.g., the seventh magnetic element 2910, the eighth magnetic element 2920, and the ninth magnetic element 2930).

In various embodiments, the foldable electronic device 1 may be implemented to include at least a portion of a combination of the embodiment of FIG. 28 (e.g., the third hook 2810 and the hook engagement portion 2820) and the embodiment of FIG. 29 (e.g., the seventh magnetic element 2910, the eighth magnetic element 2920, and the ninth magnetic element 2930).

According to an exemplary embodiment of the disclosure, the foldable electronic device 1 may include the first housing 11, the second housing 12, and the hinge module 4. The hinge module 4 may connect the first housing 11 and the second housing 12. The hinge module 4 may include a first bracket 41, a second bracket 42, and an elastic element (e.g., the first elastic element 44 or the second elastic element 45). The first bracket 41 may be disposed in the first housing 11. The second bracket 42 may be connected to the first bracket 41 to be slidable in a linear direction relative to the first bracket 41. The second bracket 42 may be rotatably connected to the second housing 12 via a shaft 43 perpendicular to the linear direction. The elastic element (e.g., the first elastic element 44 or the second elastic element 45) may be positioned between the first bracket 41 and the second bracket 42.

According to an exemplary embodiment of the disclosure, the hinge module 4 may include a linear motion guide (e.g., the first linear motion guide LMG1 or the second linear motion guide LMG2). The linear motion guide (e.g., the first linear motion guide LMG1 or the second linear motion guide LMG2) may include a linear motion guide rail (e.g., the first linear motion guide rail LMGR1 or the second linear motion guide rail LMGR2) and a linear motion slider (e.g., the first linear motion slider LMS1 or the second linear motion slider LMS2). The linear motion guide rail (e.g., the first linear motion guide rail LMGR1 or the second linear motion guide rail LMGR2) may be included in the first bracket 41. The linear motion slider (e.g., the first linear motion slider LMS1 or the second linear motion slider LMS2) may be included in the second bracket 42, and may be positioned on the linear motion guide rail (e.g., the first linear motion guide rail LMGR1 or the second linear motion guide rail LMGR2).

According to an exemplary embodiment of the disclosure, the first bracket 41 may include a first portion 401, a second portion 402 extending from the first portion 401, and a third portion 403 extending from the first portion 401. The second bracket 42 may include a fourth portion 404, a first shaft support 421 extending from the fourth portion 404, and a second shaft support 422 extending from the fourth portion 404. The fourth portion 404 may be connected to the first portion 401 to be slidable in a linear direction relative to the first portion 401. The second portion 402 and the third portion 403 may be coupled to the second housing 12 through screw fastening. The first shaft support 421 and the second shaft support 422 may be connected to the second housing 12 via the shaft 43.

According to an exemplary embodiment of the disclosure, the second bracket 42 may further include a first support wall 4231 and a second support wall 4232 extending from the fourth portion 404. The first support wall 4231 and the second support wall 4232 may be spaced apart from each other in a linear direction. The second support wall 4232 may be positioned between the first support wall 4231 and the shaft 43. The first portion 401 of the first bracket 41 may be at least partially positioned in the space defined by the fourth portion 404, the first support wall 4231, and the second support wall 4232. An elastic element (e.g., the first elastic element 44 or the second elastic element 45) may be disposed between the first portion 401 and the first support wall 4231.

According to an exemplary embodiment of the disclosure, one of the first housing 11 and the second housing 12 may include a hook (e.g., the first hook 2210 or the second hook 2220), while the remaining one may include a fastening portion (e.g., the first fastening portion 2110 or the second fastening portion 2120) corresponding to the hook (e.g., the first hook 2210 or the second hook 2220). The folded state of the foldable electronic device 1 may include the first folded state or the second folded state, depending on the relative position between the first bracket 41 coupled to the first housing 11 and the second bracket 42 coupled to the second housing 12. In the first folded state, interference may exist between the hook (e.g., the first hook 2210 or the second hook 2220) and the fastening portion (e.g., the first fastening portion 2110 or the second fastening portion 2120). In the second folded state, the interference between the hook (e.g., the first hook 2210 or the second hook 2220) and the fastening portion (e.g., the first fastening portion 2110 or the second fastening portion 2120) may be released.

According to an exemplary embodiment of the disclosure, the second housing 12 may include a hook (e.g., the third hook 2810). The first housing 11 may include a hook engagement portion 2820 corresponding to the hook (e.g., the third hook 2810). The folded state of the foldable electronic device 1 may include the first folded state or the second folded state, depending on the relative position between the first bracket 41 coupled to the first housing 11 and the second bracket 42 coupled to the second housing 12. In the first folded state, interference may exist between the hook (e.g., the third hook 2810) and the hook engagement portion 2820. In the second folded state, the interference between the hook (e.g., the third hook 2810) and the hook engagement portion 2820 may be released.

According to an exemplary embodiment of the disclosure, the foldable electronic device 1 may further include a first magnetic element (e.g., the seventh magnetic element 2910) positioned in the second housing 12. The foldable electronic device 1 may further include a second magnetic element (e.g., the eighth magnetic element 2920) and a third magnetic element (e.g., the ninth magnetic element 2930) positioned in the first housing 11. The folded state of the foldable electronic device 1 may include the first folded state or the second folded state, depending on the relative position between the first bracket 41 coupled to the first housing 11 and the second bracket 42 coupled to the second housing 12. In the first folded state, the attractive force between the first magnetic element (e.g., the seventh magnetic element 2910) and the second magnetic element (e.g., the eighth magnetic element 2920) may be greater than the repulsive force between the first magnetic element (e.g., the seventh magnetic element 2910) and the third magnetic element (e.g., the ninth magnetic element 2930). In the second folded state, the repulsive force between the first magnetic element (e.g., the seventh magnetic element 2910) and the third magnetic element (e.g., the ninth magnetic element 2930) may be greater than the attractive force between the first magnetic element (e.g., the seventh magnetic element 2910) and the second magnetic element (e.g., the eighth magnetic element 2920).

According to an exemplary embodiment of the disclosure, the elastic element (e.g., the first elastic element 44 or the second elastic element 45) may be a coil compression spring.

According to an exemplary embodiment of the disclosure, the first housing 11 may include a first recess 201 and a second recess 202 provided on one surface (e.g., the second surface 102) that faces the second housing 12 in the folded state of the foldable electronic device 1. The second housing 12 may include a third recess 203 and a fourth recess 204 provided on another surface (e.g., the fourth surface 104) that faces the one surface (e.g., the second surface 102) of the first housing 11 in the folded state of the foldable electronic device 1. In the folded state of the foldable electronic device 1, a combination of the first recess 201 and the third recess 203 may provide a first space configured to accommodate the first wireless earphone 31. In the folded state of the foldable electronic device 1, a combination of the second recess 202 and the fourth recess 204 may provide a second space configured to accommodate the second wireless earphone 32.

According to an exemplary embodiment of the disclosure, the foldable electronic device 1 may further include a first connection terminal 13, a second connection terminal 14, an antenna structure 73, and a power management module. The first connection terminal 13 may be positioned in the first housing 11 to correspond to the first recess 201. The second connection terminal 14 may be positioned in the first housing 11 to correspond to the second recess 202. The first connection terminal 13 may be electrically connected to the first wireless earphone 31 disposed in the first recess 201. The second connection terminal 14 may be electrically connected to the second wireless earphone 32 disposed in the second recess 202. The antenna structure 73 may be positioned in the first housing 11. The power management module may supply power, wirelessly received from an external electronic device via the antenna structure 73, to the first connection terminal 13 and the second connection terminal 14.

According to an exemplary embodiment of the disclosure, the foldable housing 10 may include the first housing 11, the second housing 12, and the hinge module 4. The hinge module 4 may connect the first housing 11 and the second housing 12. The hinge module 4 may include a first bracket 41, a second bracket 42, and an elastic element (e.g., the first elastic element 44 or the second elastic element 45). The first bracket 41 may be disposed in the first housing 11. The second bracket 42 may be connected to the first bracket 41 to be slidable in a linear direction relative to the first bracket 41. The second bracket 42 may be rotatably connected to the second housing 12 via a shaft 43 perpendicular to the linear direction. The elastic element (e.g., the first elastic element 44 or the second elastic element 45) may be positioned between the first bracket 41 and the second bracket 42.

Embodiments disclosed in the disclosure and drawings are merely presented as specific examples to easily describe technical content and aid understanding of the disclosure, and are not intended to limit the scope of the disclosure. Accordingly, the scope of the various embodiments of the disclosure should be construed as including changes or modifications of the embodiments in addition to the embodiments disclosed herein. In addition, it will be appreciated that any embodiment(s) described herein may be used with any other embodiment(s) described herein.

## Claims

1. A foldable electronic device (1) comprising:
a first housing (11) and a second housing (12); and
a hinge module (4) connecting the first housing (11) and the second housing (12),
wherein the hinge module (4) comprises:
a first bracket (41) disposed in the first housing (11);
a second bracket (42) connected to the first bracket (41) to be slidable in a linear direction relative to the first bracket 41 and rotatably connected to the second housing (12) via a shaft (43) perpendicular to the linear direction; and
an elastic member (44, 45) positioned between the first bracket (41) and the second bracket (42).

2. The foldable electronic device of claim 1, wherein the hinge module (4) comprises a linear motion guide (LMG1, LMG2), and
wherein the linear motion guide (LMG1, LMG2) comprises:
a linear motion guide rail (LMGR1, LMGR2) included in the first bracket (41); and
a linear motion slider (LMS1, LMS2) included in the second bracket (42) and positioned on the linear motion guide rail (LMGR1, LMGR2).

3. The foldable electronic device of claim 1 or 2, wherein the first bracket (41) comprises a first portion (401), a second portion (402) extending from the first portion (401), and a third portion (403) extending from the first portion (401),
wherein the second bracket (42) comprises a fourth portion (404), a first shaft support (421) extending from the fourth portion (404), and a second shaft support (422) extending from the fourth portion (404),
wherein the fourth portion (404) is connected to the first portion (401) to be slidable in the linear direction relative to the first portion (401),
wherein the second portion (402) and the third portion (403) are coupled to the second housing (12) through screw fastening, and
wherein the first shaft support (421) and the second shaft support (422) are connected to the second housing (12) via the shaft (43).

4. The foldable electronic device of claim 3, wherein the second bracket (42) further comprises a first support wall (4231) and a second support wall (4232) extending from the fourth portion (404),
wherein the first support wall (4231) and the second support wall (4232) are spaced apart from each other in the linear direction, and the second support wall (4232) is positioned between the first support wall (4231) and the shaft (43),
wherein the first portion (401) of the first bracket (41) is positioned in at least a portion of a space provided by a combination of the fourth portion (404), the first support wall (4231), and the second support wall (4232), and
wherein the elastic member (44, 45) is disposed between the first portion (401) and the first support wall (4231).

5. The foldable electronic device of any one of claims 1 to 4, wherein one of the first housing (11) and the second housing (12) comprises a hook (2210, 2220), and a remaining one comprises a coupling portion (2110, 2120) corresponding to the hook (2210, 2220), and
wherein a folded state of the foldable electronic device (1) comprises, depending on a relative position between the first bracket (41) coupled to the first housing (11) and the second bracket (42) coupled to the second housing (12), a first folded state in which interference exists between the hook (2210, 2220) and the coupling portion (2110, 2120), or a second folded state in which interference between the hook (2210, 2220) and the coupling portion (2110, 2120) is released.

6. The foldable electronic device of one of claims 1 to 4, wherein the second housing (12) comprises a hook (2810),
wherein the first housing (11) comprises a hook engagement part (2820) corresponding to the hook (2810), and
wherein a folded state of the foldable electronic device (1) comprises, depending on a relative position between the first bracket (41) coupled to the first housing (11) and the second bracket (42) coupled to the second housing (12), a first folded state in which interference exists between the hook (2810) and the hook engagement portion (2820), or a second folded state in which interference between the hook (2810) and the hook engagement portion (2820) is released.

7. The foldable electronic device of one of claims 1 to 4, further comprising:
a first magnetic element (2910) positioned in the second housing (12); and
a second magnetic element (2920) and a third magnetic element (2930) positioned in the first housing (11),
wherein a folded state of the foldable electronic device (1) comprises, depending on a relative position between the first bracket (41) coupled to the first housing (11) and the second bracket (42) coupled to the second housing (12), a first folded state in which an attractive force between the first magnetic element (2910) and the second magnetic element (2920) is greater than a repulsive force between the first magnetic element (2910) and the third magnetic element (2930), or a second folded state in which the repulsive force between the first magnetic element (2910) and the third magnetic element (2930) is greater than the attractive force between the first magnetic element (2910) and the second magnetic element (2920).

8. The foldable electronic device of one of claims 1 to 7, wherein the elastic member (44, 45) is a coil compression spring.

9. The foldable electronic device of one of claims 1 to 8, wherein, in a folded state of the foldable electronic device (1), the first housing (11) comprises a first recess (201) and a second recess (202) provided on one surface (102) that faces the second housing (12),
wherein, in the folded state of the foldable electronic device (1), the second housing (12) comprises a third recess (203) and a fourth recess (204) provided on another surface (104) that faces the one surface (102) of the first housing (11),
wherein, in the folded state of the foldable electronic device (1), a combination of the first recess (201) and the third recess (203) provides a first space configured to accommodate a first wireless earphone (31), and
wherein, in the folded state of the foldable electronic device (1), a combination of the second recess (202) and the fourth recess (204) provides a second space configured to accommodate a second wireless earphone (32).

10. The foldable electronic device of claim 9, further comprising:
a first connection terminal (13) positioned in the first housing (11) to correspond to the first recess (201) and a second connection terminal (14) positioned in the first housing (11) to correspond to the second recess (202), wherein the first connection terminal (13) is electrically connected to the first wireless earphone (31) disposed in the first recess (201), and the second connection terminal (14) is electrically connected to the second wireless earphone (32) disposed in the second recess (202);
an antenna structure (73) positioned in the first housing (11); and
a power management module configured to provide power, wirelessly received from an external electronic device via the antenna structure (73), to the first connection terminal (13) and the second connection terminal (14).
